# EUROPEAN PATENT APPLICATION

(11) **EP 4 604 353 A2**
(43) Date of publication of application: **20.08.2025**
(21) Application number: 25157619.5
(22) Date of filing: 13.02.2025
(51) Int. Cl.: H02J 7/00, G01R 31/396

(54) **SENSORY BATTERY CELL, INTELLIGENT BATTERY USING THE SENSORY BATTERY CELL, POWER BATTERY USING THE INTELLIGENT BATTERY, BATTERY MANAGEMENT SYSTEM AND RELATED METHOD THEREOF**

(30) Priority: 15.02.2024 US 202463553713 P; 18.10.2024 US 202463708858 P
(71) Applicant: Earth Top International Enterprises LTD., VG1110,Tortola (VG)
(72) Inventor: TSAI-CHUNG, Yu, 251 New Taipei City (TW); NAN-HUEI, Lee, 251 New Taipei City (TW)
(74) Representative: Charrier Rapp & Liebau

(57) **Abstract**

The present invention discloses a sensory battery cell including a plurality of battery cells arranged in a first battery network, wherein the first battery network is a series network or a parallel network or a combination thereof, and a sensing integrated circuit connected in parallel with each battery cell to sense performance parameters of the plurality of battery cells, wherein the sensing integrated circuit includes a function circuit able to take an action for the battery cell that reaches a set condition. The present invention further discloses a intelligent battery using the sensory battery cell, a power battery using the intelligent battery, a battery management system and related methods thereof.

## Description

### BACKGROUND OF THE INVENTION

### FIELD OF THE INVENTION

The invention relates to system and method for managing power battery, particularly to sensory battery cell, intelligent battery using the sensory battery cell, power battery using the intelligent battery, as well as system and method for managing these batteries.

### DESCRIPTION OF THE PRIOR ART

Batteries are broadly defined as devices capable of converting prestored energy into electrical energy for external use and widely applicable to daily life. Common applications of batteries include portable electronic apparatuses, such as smartphones, computers and watches, power sources for electric vehicles, energy-storing systems for storing renewable energy, power supply for medical equipment, and Internet of Things (IoT) devices, such as wireless sensors, providing continuous electric power for modern technology. Batteries fall under two categories: "primary batteries" and "secondary batteries." "Primary batteries" are designed to be used once and thrown away. Batteries which are rechargeable and can be reused are known as "secondary batteries," "storage batteries" or "rechargeable batteries." The term "batteries" or "battery" used herein refers to "secondary batteries," "storage batteries" or "rechargeable batteries."

The required arrangement of batteries in use depends on the power level required for a specific application. Small electronic equipment like watch and remote control usually require one or several low-capacity batteries for supplying a small amount of energy to meet user needs. Electronic equipment like smartphone and tablet require several batteries to achieve higher power level and longer endurance. To meet the need for higher power level, such as electric vehicles and energy-storing systems, a larger number of batteries units (or battery cells) are used to form high-power power batteries. The high-power power batteries achieve increased voltage, current or capacitance through a series connection, a parallel connection, a series-parallel network or a parallel-series network to ensure long-lasting, stable power supply. The network of the power batteries is designed and adjusted to meet application need.

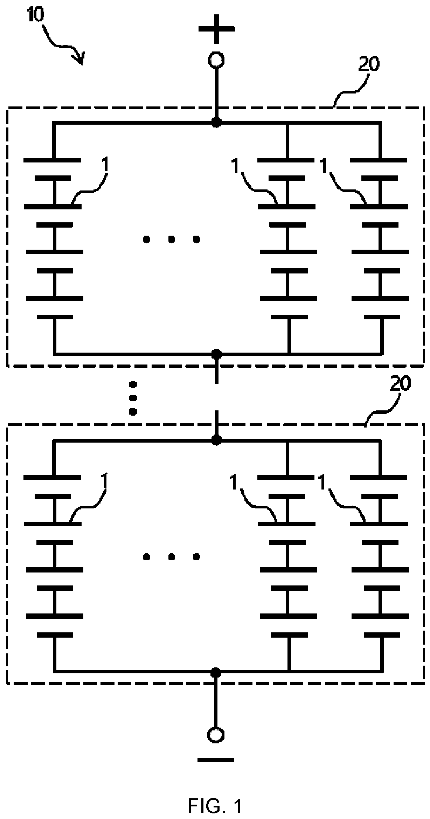

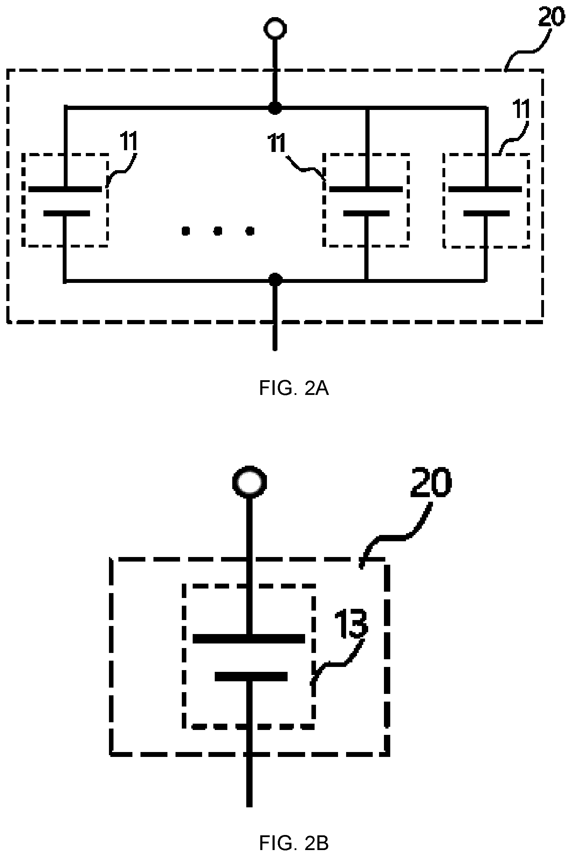

Refer to FIG. 1, FIG. 2A and FIG. 2B. FIG. 1 is a circuit diagram of a conventional power battery 10 in a series-parallel network. FIG. 2A is an equivalent circuit diagram of a battery 20 shown in FIG. 1. FIG. 2B is a further equivalent circuit diagram of the battery 20 shown in FIG. 2A. The power battery 10 shown in FIG. 1 comprises a plurality of batteries 20 in series connection, and each battery 20 comprises a plurality of battery cells 1 in a series-parallel network. Each battery cell 1 provides a rated voltage (i.e., the average voltage that can be outputted during the longest time period, measured in volts (V)), whereas battery capacity (i.e., the current value allowing the battery capacity to become 0 through one-hour discharge, measured in milliampere-hour (mAh)) is denoted by the reference sign Q. The equivalent circuit of the battery 20 shown in FIG. 2A can be regarded as a parallel connection network of a plurality of equivalent batteries 11, and each equivalent battery 11 can be regarded as a series connection network of a plurality of battery cells 1. Given a series connection of four battery cells 1, the equivalent batteries 11 have a rated voltage of 4V and battery capacity Q is I mAh. The equivalent circuit of the battery 20 shown in FIG. 2B can be regarded as an equivalent battery 13, and the equivalent battery 13 can be regarded as a parallel connection network of a plurality of equivalent batteries 11. Given a 4 series - 10 parallel network of the battery 20 shown in FIG. 1, the battery 20 has a rated voltage of 4V and battery capacity Q of 101 mAh. For exemplary purpose, the power battery 10 comprises 10 batteries 20 in series connection and has a rated voltage of 40V and battery capacity Q of 101 mAh or 400VI mWh.

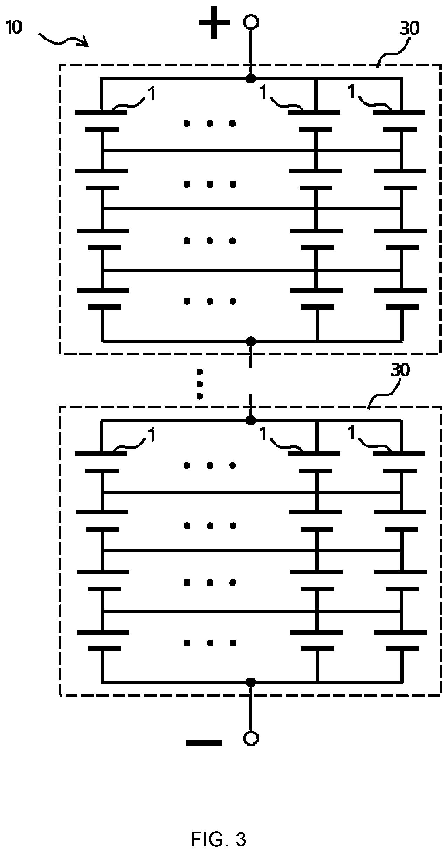

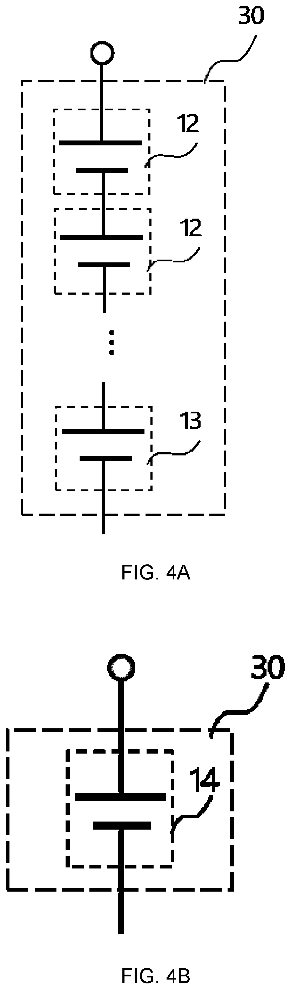

Refer to FIG. 3, FIG. 4A and FIG. 4B. FIG. 3 is a circuit diagram of another conventional power battery 10 in a parallel-series network. FIG. 4A is an equivalent circuit diagram of a battery 30 shown in FIG. 3. FIG. 4B is a further equivalent circuit diagram of the battery 30 shown in FIG. 4A. Referring to FIG. 3, the power battery 10 comprises a plurality of batteries 30 in series connection, and each battery 30 comprises a plurality of battery cells 1 in a parallel-series network, wherein the rated voltage provided by each battery cell 1 is denoted by the reference sign V, and battery capacity is denoted by the reference sign Q. As shown in FIG. 4A, the equivalent circuit of the battery 30 can be regarded as a series connection network of a plurality of equivalent batteries 12, and each equivalent battery 12 can be regarded as a plurality of battery cells 1 in parallel connection. For exemplary purpose, a parallel connection of the equivalent battery 12 comprising 10 battery cells 1 has a rated voltage of V volt and battery capacity Q of 101 mAh. Referring to FIG. 4B, the equivalent circuit of the battery 30 can be regarded as an equivalent battery 14, and the equivalent battery 14 can be regarded as a plurality of equivalent batteries 12 in series connection. For exemplary purpose, given a 10 parallel - 4 series network of the battery 30 shown in FIG. 3, the battery 30 has a rated voltage of 4V volt and battery capacity Q of 101 mAh. For exemplary purpose, the power battery 10 comprises 10 battery 30 in series connection and has a rated voltage of 40V volt and battery capacity Q of 101 mAh or 400VI mWh.

Therefore, the greater the applicable power level need, the larger number of battery cells of the power battery is the required, and even more than one thousand or ten thousand battery cells are required. For exemplary purpose, the power battery system of Tesla electric vehicles requires around 10,000 battery cells. Verified information disclosed by China since 2023 shows that new Model 3 rear-driven and Model 3 LR are equipped with 60 KWh battery capacity and 78.4 KWh battery capacity, respectively.

According to a comparison between a ternary lithium battery and a lithium iron phosphate (LiFePO4) battery in terms of their performance, although lithium iron phosphate has advantages, such as low cost, long cycle service life and a high degree of safety, ternary lithium battery cell is prevailing in the power battery market of medium and high-end cars. It is because ternary lithium battery cells have advantages, such as high energy density, long endurance, high performance output, small volume, and consistent quality and thus meet the requirements of medium and high-end electric vehicles, i.e., long endurance, reduced weight and volume. Thus, ternary lithium battery cells are the preferred choice for medium and high-end electric vehicles. Battery quality deeply affects the charging and discharging performance as well as service life, while electric vehicles require numerous battery cells, it is difficult to ensure equal service life and the same degree of safety quality of more than one thousand or ten thousand battery cells. Therefore, the capacity and service life of a power battery depend on the consistent quality of battery cells, which is an issue in industrial development.

In recent years, there were some reported incidents where electric vehicles spontaneously caught fire while being charged or when subjected to external impacts, endangering drivers' and passengers' safety. As a result, potential electric vehicle buyers nowadays attach great importance to the safety of power batteries or hesitate to buy electric vehicles, and some potential electric vehicle buyers even have a phobia of vehicle batteries. Daily use of power batteries may cause three types of irreversible damage to battery cells as follows: overcharge, overdischarge, and quick charge. In this regard, some experts opine that the number of instances of the quick charge of battery cells should be reduced. If the quality of tens of thousands of battery cells is inconsistent, damage caused to power batteries will speed up. A related description is presented below.

Overcharge affects battery performance. Overcharge refers to the phenomenon of continuously charging a battery after the battery has been fully charged. In general, after being fully charged, a battery does not exhibit a significant increase in its internal pressure. However, in case of an overly large charging current or an overly long charging session, there will be not enough time to deplete the produced oxygen, leading to unfavorable phenomena, such as increased internal pressure, battery deformation, leakage, and significantly deteriorated electrical performance.

Overdischarge affects battery performance. Overdischarge refers to the phenomenon of continuously discharging a battery after the battery has fully discharged its internally stored power and its voltage has reached a specific level. The discharge cutoff voltage usually depends on the discharge current; thus, battery overdischarge, especially large-current overdischarge and repeated overdischarge, is likely to bring disastrous consequences to batteries. In general, overdischarge causes an increase in battery internal pressure and causes destruction to the reversibility of cathode and anode active substances; as a result, even if the battery is charged, the battery can only restore a portion of its function, and the degradation of its capacity will be significant.

Quick charge affects service life of battery cells. Cell materials and design have been improved, allowing lithium ions to move into and move out of a battery electrode quickly. However, high voltage and current still cause the battery to undergo wear and tear. Furthermore, products of quick charge solutions rarely cope with, from a battery perspective, their effect on the service life of battery cells.

Furthermore, after long-term use, battery cells quality inconsistency causes a difference in battery capacity and causes leakage and zero voltage to a power battery comprising battery cells that are different from each other in terms of capacity. A network of battery cells of a conventional power battery cannot be adjusted, nor is it possible to precisely sense any performance parameter or degraded state of each battery cell. Thus, during a process of charging a power battery, the capacity difference causes some battery cells of the power battery to be overcharged and some other battery cells of the power battery to be not fully charged. Moreover, during a process of discharging the power battery, the battery cells with high capacity are not fully discharged, but the battery cells with low capacity are overdischarged. The vicious cycle speeds up the damage caused to the power battery.

For exemplary sake, as shown in FIG. 1 and FIG. 2A, the equivalent battery 11 of the battery pack 20 is equivalent to a series connection of four battery cells 1. If one of the four battery cells 1 performs a decrease in a rated voltage V because of quality degradation, the rated voltage of the equivalent battery 11 will be less than 4V. Since the network cannot be adjusted, the battery cell 1 with quality degradation is overcharged whenever the battery pack 20 performs rated charging. Even if the other three battery cells 1 are charged to attain the rated voltage V but the rated voltage of the equivalent battery 11 is less than 4V, the other three battery cells 1 will perform an overcharge phenomenon. Furthermore, when one of the battery cells 1 exhibits quality degradation and thus the terminal voltage of the equivalent battery 11 is lower than the terminal voltage of the other equivalent battery 11, the completion of the charging of the battery pack 20 is followed by the discharging of the other equivalent battery 11 to thereby charge the equivalent battery 11 with quality degradation, generating additional heat. Whenever the battery pack 20 discharges, the equivalent battery 11 with quality degradation is overdischarged, but the other equivalent battery 11 is not fully discharged. Owing to the long-term use of the power battery 10, the damage caused to the battery pack 20 speeds up, and thus the power battery 10 gets damaged sooner to the detriment of its service life.

For exemplary sake, likewise, as shown in FIG. 3, FIG. 4A and FIG. 4B, the equivalent battery 12 of the battery pack 30 is equivalent to a parallel connection of several battery cells 1. In the situation where one of the battery cells 1 of the equivalent battery 12 undergoes quality degradation that causes capacity deterioration and the network is not adjustable, whenever the equivalent battery 12 discharges, the battery cell 1 with quality degradation is overdischarged, and its terminal voltage becomes lower than the terminal voltage of the battery cells 1 of another parallel connection, causing the battery cells 1 of the other parallel connection to charge the battery cell 1 with quality degradation, generating additional heat. Furthermore, the equivalent battery 12 with quality degradation causes the decrease in the rated voltage V; thus, every time the battery pack 30 performs a charging, the equivalent battery 12 with quality degradation is overcharged. Even if the other equivalent battery 12 is charged to attain the rated voltage V but the rated voltage of the equivalent battery 14 is insufficient, the other equivalent battery 12 will perform an overcharge phenomenon. Owing to the long-term use of the power battery 10, the damage caused to the battery pack 30 speeds up, and thus the power battery 10 gets damaged sooner to the detriment of its service life.

Therefore, consumers nowadays, especially those who are going to sell their electric vehicles to purchase new ones, are concerned with the service life of power batteries. The prior art does not provide any solution to evaluate the actual quality and service life of used power batteries or every battery cell, and in consequence prices of second-hand electric vehicles are affected. Similarly, potential buyers of second-hand electric vehicles are concerned with the service life of power batteries and may even request sellers to offer a battery warranty, which is not an unreasonable request, because a power battery is typically worth 10,000 U.S. dollars or so, and no potential buyer wants a second-hand electric vehicle that comes with a bad power battery.

Battery cell consistency is an important indicator of power battery quality. Battery performance level depends on the material which battery cells are made of. If a "high-power" power battery lacks battery cell consistency, battery cells in multilayer series-parallel connection or in parallel-series connection will lack battery cell consistency and thereby directly affect the capacity and service life of the power battery, compromising safety as well as the manufacturing cost and maintenance cost of the power battery. In view of this, battery cell consistency is an important indicator of conventional power batteries to maintain the quality thereof.

Capacity and charging/discharging voltage among the battery cells are inconsistent caused by the battery cell consistency. This problem causes not only battery performance, but also plants a safety concern in power battery application. For instance, medium or high-end cars that adopt the power battery comprising ternary lithium battery cells occasionally catch fire during quick charge or after car crash.

Battery cells may lack consistency for various reasons in terms of battery materials (e.g. purity and proportions of electrolytes, purity of solvents, particles of active materials and their distribution, stability of constituents of materials, uniformity of stability of separator parameters, gaps between separators, thickness errors, and static electricity), production processes (e.g. poor stability of cell production equipment, low degree of automation, low precision of equipment processing, and poor coordination between equipment and processes), BMS systems, and predelivery quality control, which affects the consistency of the battery cells of the power battery. Furthermore, the quality of the design of BMS systems also directly affects the consistency of the battery cells of the power battery.

Attempts made by the industrial sector to address the issue with consistency of battery cells of power batteries always focus on the interior of a battery, separators, and electrolytes. However, electric vehicles require a lot of high-power power batteries, and it is difficult to ensure that tens of thousands of battery cells have the same service life and the same safety quality.

Owing to the production process of battery cells, the stability and stability uniformity of the constituents of the battery material, the storage environment, and the charging and discharging technique, none of the battery cells can maintain the consistency of performance parameters or degraded state after its long-term use, which directly affects the capacity and service life of the power battery, raising a safety risk, and a problem for producing power battery as well as maintenance cost.

Conventional power batteries for meeting different energy needs are "high-power" power batteries each comprising hundreds of battery cells, thousands of battery cells, or tens of thousands of battery cells. The prior art does not provide any solution to precisely sense the performance parameters or degraded state of each battery cell, and thus the conventional power batteries cannot take an action to unsatisfactory battery cells that lie below a standard deviation.

According to the prior art, conventional power batteries cannot precisely sense the performance parameters or degraded state of each battery cell but can only evaluate power battery capacity and service life according to performance parameters of a partial "equivalent battery." If the consistency issue of the battery cells prevents the performance parameters of the partial "equivalent battery" from passing an evaluation standard, the entire power battery will have to be replaced, leading to excessive wear and tear of the battery cells and a waste of cell material resources and causing users to incur overly high maintenance cost.

According to the prior art, conventional power batteries cannot precisely sense the performance parameters or degraded state of each battery cell but can only display or provide information about the power battery in aspect of the performance of "one single equivalent battery", and cannot display or provide the performance parameters of each of the battery cells of the power battery, and cannot mark the position of each battery cell in a network of the power battery.

The performance of battery cells in a temperature environment varies from cell material to cell material. According to the prior art, conventional power batteries cannot precisely sense the performance parameters or degraded state of each battery cell, and it is difficult to compose various types of battery cells in usage because it is unable to manage charging and discharging among the various types of batteries and adapt the conventional power battery for usage in an extreme temperature environment.

Therefore, conventional power batteries have drawbacks or have room for improvement as described below:

First, conventional power batteries serve as system energy sources. However, when the degradation of the performance of one or some of the battery cells causes the deterioration of the charging and discharging efficiency of the power batteries, the power batteries cannot identify those battery cells having performance degradation and thus cannot achieve updated or real-time isolation of the battery cells with performance degradation.

Second, conventional power batteries cannot carry out precise measurement of the performance of each battery cell. As a result, when the charging and discharging efficiency of the power batteries deteriorates, it is impossible to identify which performance-degraded battery cell or battery cells cause(s) the efficiency deterioration, nor is it possible to discern performance-degraded battery cells or locate them from a battery network of the power batteries.

Third, conventional power batteries are packaged with a battery network of irreplaceable battery cells, if the charging and discharging efficiency of the packaged power batteries deteriorates, replacement of the packaged power batteries will be only solution instead of replacement of a partial battery cells.

Fourth, a battery network composed of battery cells of conventional power batteries is determined and unadjustable. When the performance of one or some of the battery cells degrades, the charging and discharging efficiency of conventional power batteries with the unchangeable battery network cannot be improved.

Fifth, conventional battery management systems do not allow a power battery to be composed of mixed battery cells made of different cell materials respectively, to perform battery management, and to perform mutual charging and discharging. For example, sodium-ion batteries allow ternary lithium batteries to provide operable temperature environment at a much colder environment.

Sixth, the battery cell state of conventional power batteries cannot be sensed, nor are their battery networks controllable, rendering it impossible to accomplish an intelligent battery.

Seventh, conventional power batteries each composed of ternary lithium battery cells cannot instantly isolate performance-degraded ternary lithium battery cells, and in consequence the power batteries are likely to end up with charging and discharging performance degradation or end up in highly risky crises.

Eighth, conventional power batteries are not capable of selectively starting battery balance management for enhancing power battery performance and service life.

Nineth, Conventional power batteries cannot provide a user interface for displaying the power battery and its battery network in series connection, in parallel connection, in series-parallel connection, or in parallel-series connection and the usage state of each battery cell.

### SUMMARY OF THE INVENTION

The present invention provides a power battery based on sensory chips (or integrated circuits) to precisely sense performance parameters (V, I, R, T) of each battery cell and take an action (isolation or power level balance) to cope with inconsistent battery cells that result from long-term use to accomplish an "intelligent battery" with high industrial applicability.

Furthermore, the performance parameters of each battery cell are precisely sensed, and the quality of each battery cell is evaluated with a mean and a standard deviation in order to maintain the quality of the power battery.

One of the objectives of the present invention is to provide a power battery based on sensory chip to sense performance parameters of each battery cell and dynamically adjust a battery network of the power battery.

One of the objectives of the present invention is to provide a sensory chip and a method thereof.

One of the objectives of the present invention is to provide a battery network and a method thereof.

One of the objectives of the present invention is to provide a gateway chip and a method thereof.

One of the objectives of the present invention is to provide a sensory battery cell and a method thereof.

One of the objectives of the present invention is to provide an intelligent battery and a method thereof.

One of the objectives of the present invention is to provide a power battery and a method thereof.

One of the objectives of the present invention is to provide a battery management system and a method thereof.

One of the objectives of the present invention is to provide a battery history-related information management system and a method thereof.

One of the objectives of the present invention is to provide a battery state display system and a method thereof.

### BRIEF DESCRIPTION OF THE DRAWINGS

The present invention can be further understood with reference to the following drawings and descriptions. Non-limiting and non-exhaustive examples are described with reference to the following figures. The components in the drawings are not necessarily to actual size, the emphasis is on illustrating the structure and principles.
FIG. 1 is a circuit diagram of a conventional power battery in a series-parallel network.
FIG. 2A and FIG. 2B are equivalent circuit diagrams shown in FIG. 1.
FIG. 3 is a circuit diagram of another conventional power battery in a parallel-series network.
FIG. 4A and FIG. 4B are equivalent circuit diagrams shown in FIG. 3.
FIG. 5 illustrates a block diagram of an intelligent battery according to the present invention.
FIG. 6A and FIG. 6B illustrate block diagrams of two types of sensory battery cells according to the present invention.
FIG. 7 illustrates a block diagram of a sensing integrated circuit shown in FIG. 6.
FIG. 8A illustrates a detailed circuit diagram of a function circuit shown in FIG. 6A.
FIG. 8B illustrates a detailed circuit diagram of a function circuit shown in FIG. 6B.
FIG. 8C illustrates another detailed circuit diagram of a function circuit shown in FIG. 6B.
FIG. 9 illustrates a block diagram in which a plurality of sensory battery cells are parallel-connected.
FIG. 10 illustrates a block diagram of a gateway integrated circuit according to the present invention.
FIG. 11 illustrates a block diagram of a power battery according to the present invention.
FIG. 12 illustrates a block diagram of series balance function circuits of series-connected intelligent batteries according to the present invention.
FIG. 13A and FIG. 13B illustrate circuit diagrams of series-connected intelligent batteries that implement series balance.
FIG. 14 shows a message graphic of a battery management system according to the present invention.
FIG. 15 shows a flow chart of a battery management method according to the present invention.
FIG. 16A illustrates a schematic view of a battery state of the power battery according to the present invention.
FIG. 16B illustrates a schematic view of another battery state of the power battery according to the present invention.
FIG. 16C illustrates a screen display showing a battery state of a sensory battery cell according to the present invention.
FIG. 16D illustrates another screen display showing a battery state of a sensory battery cell according to the present invention.

### DETAILED DESCRIPTION OF THE EMBODIMENTS

The present invention will now be described more completely with reference to the accompanying drawings, in which specific embodiments are shown by way of illustration. However, the claimed subject matter can be embodied in many different forms, and therefore the construction of the encompassed or claimed subject matter is not limited to any example embodiments disclosed in this specification. The embodiments are only for illustration. Likewise, this invention is intended to provide a reasonably broad scope to the claimed subject matter as claimed or encompassed. Furthermore, the drawings and illustrations in this disclosure are generally not to scale and are not intended to correspond to actual relative sizes.

For purposes of consistency and ease of understanding, identical features are identified by reference numbers in the illustrative drawings, although in some examples they are not. However, features in different embodiments may differ in other aspects and therefore should not be narrowly limited to those shown in the drawings. The terms "first" and "second" in the description of the present invention and the above-mentioned drawings are used to distinguish different objects, rather than describing a specific sequence. The terms "upper" and "lower" refer to the relative positions of adjacent objects, rather than the absolute upper and lower positions. The terminology of the embodiments contained in this specification will be explained below.

Integrated circuit (also known as chip) is a miniaturized circuit formed by integrating elements manufactured from semiconductor materials and wiring into a substrate.

Battery cell (also known as cell or battery unit) is the smallest battery cell constituting the sensory battery cell or intelligent battery of the present invention and can be implemented in the form of a conventional battery cell according to the prior art or in the form of a similar energy-storing unit.

In all the embodiments of the present invention, degraded battery cell or aging battery cell does not mean the cell is unable to perform charging or discharging. In different embodiments of the present invention, degraded battery cell or aging battery cell has an internal resistance, precisely measured with the method of the present invention, that is higher than internal resistance in an initial state by 3% or 5% or higher than a predetermined threshold, or has a battery capacity, precisely measured with the method of the present invention, that is lower than battery capacity in an initial state by 5% or 10% or lower than a predetermined threshold, or a difference between the battery parameter precisely measured with the method of the present invention and the battery parameter in an initial state reaches a predetermined threshold. An action carried out with the system or method of the present invention is effective in allowing degraded battery cell or aging battery cell to be temporarily isolated from the battery networks of the present invention to thereby avoid overcharge or overdischarge. Alternatively, the cell can be rejoined in the battery networks of the present invention to perform charging or discharging.

According to the present invention, the sensory battery cell comprises a plurality of battery cells and a sensory chip. The battery cells are arranged in a series connection network or a parallel connection network. A plurality of pins of the sensory chip are parallel-connected to each battery cell and controllably start or shut down the charging and discharging loops of the plurality of battery cells.

According to the present invention, the intelligent battery comprises the plurality of sensory battery cells of the present invention and a gateway chip of the present invention. The sensory battery cells and the gateway chip are arranged in a parallel connection network.

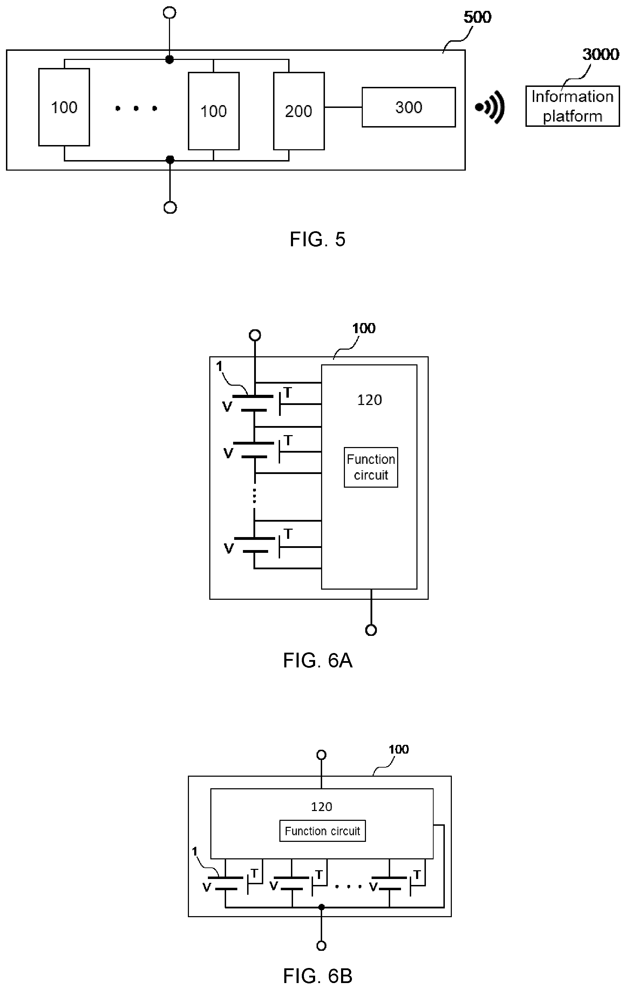

With reference to FIG. 5, FIG. 6A and FIG. 6B, FIG. 5 shows a block diagram of an intelligent battery 500 of the present invention, FIG 6A and FIG. 6B show block diagrams of two types of sensory battery cells of the present invention respectively. In an embodiment of the present invention, the intelligent battery 500 comprises a plurality of sensory battery cells 100 and a gateway integrated circuit 200. The sensory battery cells 100 and the gateway integrated circuit 200 are arranged in a parallel connection network. The sensory battery cells 100 each comprise a plurality of battery cells and a sensing integrated circuit. The sensing integrated circuit senses the temperature of each battery cell and measures performance parameters of each battery cell. The performance parameters include but are not limited to open-circuit voltage (Vopen) associated with the battery temperature, charging and discharging current, charging and discharging internal resistance, number of instances of charging and discharging, and result calculated based on the aforesaid parameters or measurements. The gateway integrated circuit 200 communicates with each sensing integrated circuit to receive the performance parameters of each battery cell of the intelligent battery 500. In a further embodiment of the present invention, the gateway integrated circuit 200 evaluates a degraded one of the plurality of battery cells according to the performance parameters of each battery cell. The plurality of battery cells of the intelligent battery 500 include battery cells made of different materials. The sensing integrated circuit precisely measures the performance parameters of each battery cell to maintain the charging and discharging of the battery cells made of different materials, preventing overcharge and overdischarge phenomena.

In another embodiment of the present invention, an intelligent battery 500 comprises a plurality of sensory battery cells 100, a gateway integrated circuit 200 and a wireless module 300. The sensory battery cells 100 and the gateway integrated circuit 200 are arranged in a parallel connection network, and each sensory battery cell 100 comprises a plurality of battery cells and a sensing integrated circuit. The sensing integrated circuit precisely senses the temperature of each battery cell and measures the performance parameters of each battery cell. The task of the gateway integrated circuit 200 is to communicate with each sensing integrated circuit and receive from each sensing integrated circuit the performance parameters of each battery cell of the intelligent battery 500. The gateway integrated circuit 200 communicates with an information platform through the wireless module 300 to send the performance parameters of each battery cell of the intelligent battery 500 to the information platform 3000. The information platform 3000 is a cloud server system or a vehicular system of an electric vehicle to evaluate a degraded one of the plurality of battery cells.

Referring to FIG. 6A and FIG. 6B, there are shown block diagrams of two types of sensory battery cells 100 of the present invention respectively, and they differ from each other in terms of the battery networks of a plurality of battery cells 1, namely a series connection network and a parallel connection network respectively. According to the present invention, the sensory battery cells 100 each comprise a plurality of battery cells 1, a plurality of temperature sensors and a sensing integrated circuit 120, wherein each temperature sensor senses a temperature T of a corresponding one of the battery cells 1. The sensing integrated circuit 120 comprises a function circuit and a plurality of pins. A portion of the pins of the sensing integrated circuit 120 are electrically connected to the cathode and the anode of the battery cells 1, respectively. A portion of the pins of the sensing integrated circuit 120 are electrically connected to temperature sensors respectively, allowing the sensing integrated circuit 120 to sense the temperature of the battery cells 1 and a terminal voltage defined by the cathode and the anode.

When one of the battery cells 1 meets a critical state, the sensing integrated circuit 120 enables the function circuit FC to take an action against at least one or all of the battery cells according to an external instruction. The external instruction is a management instruction of the battery management system and method of the present invention. In a variant embodiment of the present invention, a criterion against which a battery cell 1 is found having attained a critical state can be defined by at least one portion of the performance parameters of the battery cell 1. For examples, the internal resistance precisely measured by the method of the present invention becomes higher than the internal resistance in an initial state by 3% or 5% or higher than a predetermined threshold, the battery capacity precisely measured by the method of the present invention becomes lower than the battery capacity in an initial state by 5% or 10% or lower than a predetermined threshold, or a difference between the battery parameter precisely measured by the method of the present invention and the battery parameter in an initial state reaches a predetermined threshold. The sensory battery cell 100 takes the action through the function circuit FC that causes at least one battery cell or all battery cells to be isolated from the battery network or performs power level balance on at least a portion of the battery cells. In a further embodiment of the present invention, the function circuit FC causes at least one battery cell or all battery cells to be temporarily isolated from the battery networks or to rejoin in the battery networks to perform charging or discharging, or adjusts the battery networks.

In a variant embodiment of the present invention, the sensing integrated circuit 120 enables the function circuit FC without the need of an external instruction. For instance, when the sensing integrated circuit 120 senses that the temperature T of one of the battery cells 1 reaches an alert temperature, the function circuit FC causes the sensory battery cell 100 to be isolated from the battery networks. Likewise, when the sensing integrated circuit 120 senses that the terminal voltage of one of the battery cells 1 is lower than the terminal voltage of the other battery cells 1 by a specific value, the function circuit FC can implement power level balance.

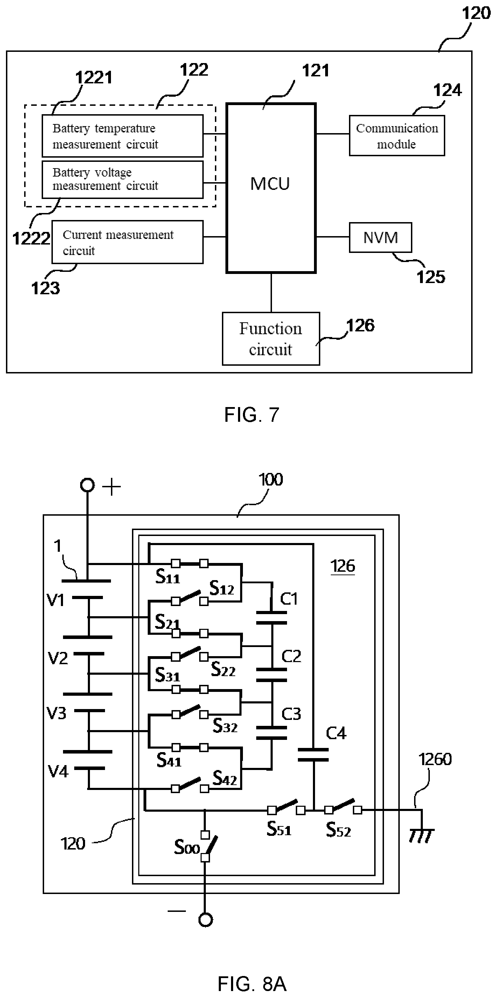

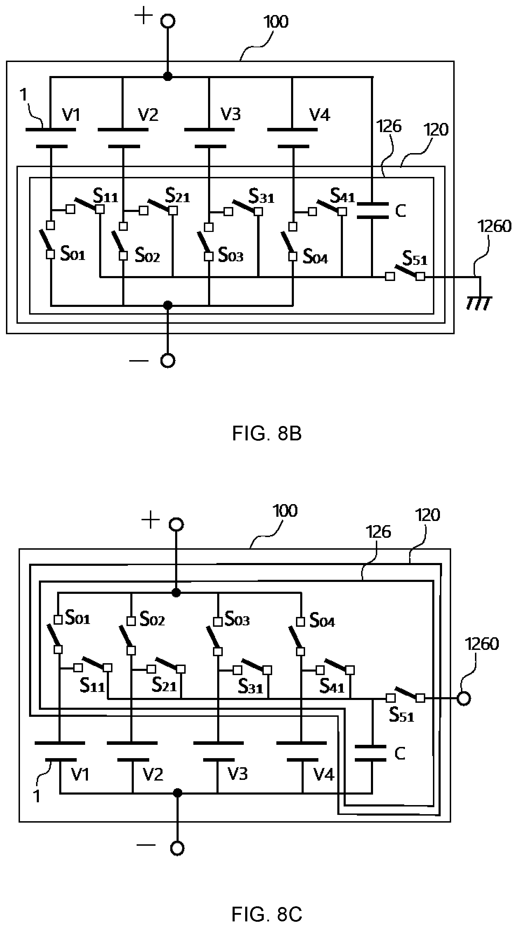

Referring to FIG. 7, there is shown a block diagram of the sensing integrated circuit 120 shown in FIG. 6A and FIG. 6B, wherein the function circuit 128 of the sensing integrated circuit 120 varies depending on battery network configuration shown in FIG. 8A and FIG. 8B, respectively. According to the present invention, the sensing integrated circuit 120 comprises: a microcontroller unit (MCU) 121, a plurality of measurement circuits 122 corresponding in position to a plurality of battery cells 1, a current measurement circuit 123, a communication module 124, a non-volatile memory (NVM) 125 and a function circuit 126. Each of the measurement circuits 122 corresponding in position to the battery cells 1 comprises: a battery temperature measurement circuit 1221 electrically connected to a temperature sensor for a corresponding one of the battery cells 1 to measure the temperature T of the battery cell 1; and a battery voltage measurement circuit 1222 parallel-connected to the corresponding one of the battery cells 1 to measure the terminal voltage of the battery cell 1. The current measurement circuit 123 measures the charging and discharging current of the sensory battery cell 100. The charging and discharging current is the current passing by a switch S₀₀ in FIG. 8A or the current passing by switches S₀₁ to S₀₄ in FIGs. 8B and 8C. The NVM 125 stores a program code, including but not limited to serial numbers related to the sensory battery cells 100, user serial numbers, a serial number of each battery cell 1, and initial performance parameters. The function circuit 126 is electrically connected to the battery networks to allow the sensing integrated circuit 120 of the present invention to enable the function circuit 126 according to an external instruction to take an action against at least one battery cell 1 or all battery cells 1. The MCU 121 executes a program code stored in the NVM 125 to perform all the functions and tasks of the sensing integrated circuit 120 of the present invention.

Regarding the sensing integrated circuit 120 of the present invention, the MCU 121 is electrically connected to each measurement circuit 122 and the current measurement circuit 123 to receive the charging and discharging current, the terminal voltage, and the temperature T of each battery cell 1 and measure the performance parameters (associated with the temperature T) of each battery cell 1 accordingly. The performance parameters associated with the temperature T include but are not limited to the open-circuit voltage (Vopen), the charging and discharging current, and the charging and discharging internal resistance. The MCU 121 controllably causes the communication module 124 to communicate with the gateway integrated circuit 200 in order for the performance parameters of the battery cells 1 of the sensory battery cells 100 to be sent to the gateway integrated circuit 200.

When the MCU 121 receives an external instruction through the communication module 124, the MCU 121 accordingly controllably causes the function circuit 126 to take an action against at least one battery cell 1 or all battery cells 1. The action comprises: isolating at least one battery cell 1 or all battery cells 1 from the battery network, or performing power level balance on at least a portion of the battery cells 1. In a further embodiment of the present invention, the function circuit 126 causes at least one battery cell 1 or all battery cells 1 to be temporarily isolated from the battery network of the intelligent battery 500 or to be rejoined in the battery network of the intelligent battery 500 to perform charging or discharging. Referring to FIG. 8A and FIG. 8B, the function circuit 126 is electrically connected to a plurality of battery cells 1, as described below.

Referring to FIG. 8A, there is shown a detailed circuit diagram of the function circuit 126 of the sensing integrated circuit 120 shown in FIG. 6A. For exemplary purpose, this embodiment is exemplified by four battery cells 1, but the present invention is not limited thereto. According to the present invention, the sensory battery cell 100 has a cathode and an anode. Charging or discharging electrical path is formed between the cathode and the anode. A plurality of battery cells 1 forms a battery network on the charging and discharging electrical path in the form of a series connection. The sensing integrated circuit 120 comprises a function circuit 126 and a plurality of pins. One of the pins is electrically connected to the cathode, another pin is electrically connected to the anode. The function circuit 126 comprises a loop switch S₀₀ and a power level balance circuit. The loop switch S₀₀ is located on the charging and discharging electrical path and adapted to disconnect or connect the charging and discharging electrical path of the sensory battery cells 100. When the MCU 121 controllably causes the loop switch S₀₀ to temporarily disconnect, the battery voltage measurement circuit 1222 can measure Vopen of each battery cell 1. The power level balance circuit is controlled by the MCU 121 to thereby implement a parallel connection power level balance between the sensory battery cells 100 and a series connection power level balance between the battery cells 1.

In a variant embodiment of the present invention, the loop switch S₀₀ is located on the charging and discharging electrical path and disposed between the anode and the battery cells 1 in series connection, as shown in FIG. 8A, or between the cathode and the battery cells 1 in series connection. The MCU 121 controllably causes the loop switch S₀₀ to be turned OFF or turned ON according to an external instruction to allow the function circuit 126 to disconnect or connect the charging and discharging electrical path of the sensory battery cell 100 to selectively isolate all the battery cells 1 in order to perform charging or discharging, or adjust the battery network.

The power level balance circuit of the function circuit 126 comprises a plurality of switching networks composed of a plurality of switches and a plurality of capacitors, wherein the switches Sᵢⱼ, i=1···4, j=1,2 of the switching networks are used to switch capacitors C1, C2, and C3 to balance the series connected battery cells, the switches S₅₁ and S₅₂ of the switching networks are used to switch capacitor C4 to balance the parallel connected battery cells. The plurality of capacitors include capacitors C1, C2, C3 for use in a series connection balance and a capacitor C4 for use in a parallel connection balance. The power level balance circuit of the function circuit 126 is parallel-connected to each battery cell 1 through a portion of the pins.

When the power level balance circuit does not perform a series connection balance function, the switches are turned OFF, and the capacitors C1, C2, C3 do not transfer energy. When the MCU 121 enables the power level balance circuit according to an external instruction to perform a series connection balance function, the MCU 121 controls the switches according to measurement results of the battery voltage measurement circuit 1222 in order to select each of capacitors C1, C2, C3 to transfer energy between neighboring battery cells 1 to balance the power level of the battery cells 1. The MCU 121 controllably causes switches S₁₁, S₂₁ to simultaneously turn ON or controllably causes switches S₁₂, S₂₂ to simultaneously turn ON, allowing the capacitor C1 to be selectively parallel-connected to the battery cell V1 or V2. The MCU 121 controllably causes switches S₂₁, S₃₁ to simultaneously turn ON or controllably causes switches S₂₂, S₃₂ to simultaneously turn ON, allowing the capacitor C2 to be selectively parallel-connected to the battery cell V2 or V3. The MCU 121 controllably causes switches S₃₁, S₄₁ to simultaneously turn ON or controllably causes switches S₃₂, S₄₂ to simultaneously turn ON, allowing the capacitor C3 to be selectively parallel-connected to the battery cell V3 or V4. Therefore, when a plurality of battery cells 1 are in series connection, the sensing integrated circuit 120 of the present invention can perform a series connection balance function between a higher energy-storing battery cell and a lower energy-storing battery cell.

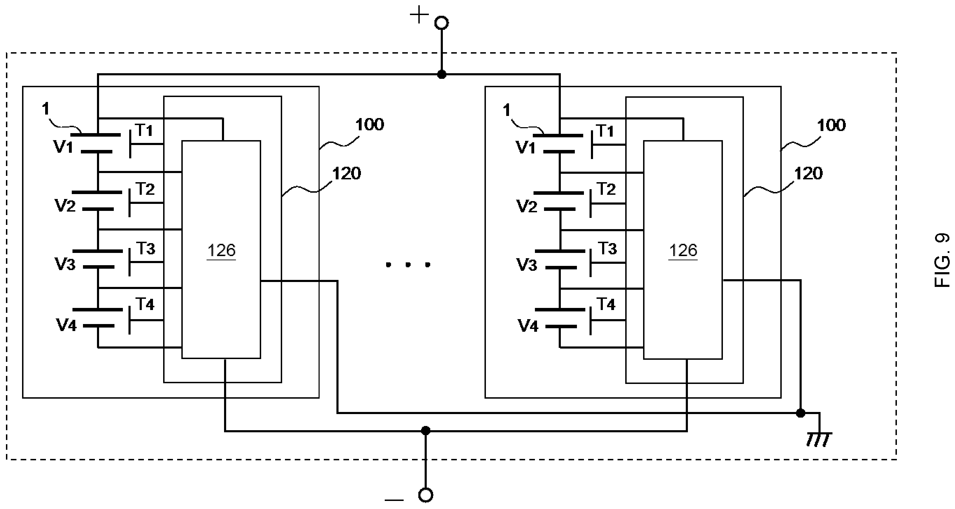

When the battery voltage measurement circuit 1222 of the sensing integrated circuit 120 measures the Vopen of each battery cell 1, the sensing integrated circuit 120 instructs via the gateway integrated circuit 200 the other sensing integrated circuit 120 to disable measurement, preventing power interruption during discharge of the intelligent battery. Furthermore, the sensing integrated circuit 120 has common pins. When a plurality of sensory battery cells 100 are parallel-connected, common ground pins of the sensing integrated circuits are also electrically connected, as shown in FIG. 9, allowing the sensory battery cells 100 in parallel connection to perform a parallel connection balance function. In the power level balance circuit by the function circuit 126, the capacitor C4 has one end electrically connected to a cathode and the other end electrically connected to switches S₅₁, S₅₂; when the function circuit 126 is disabled, the switches S₅₁, S₅₂ are turned OFF, preventing the capacitor C4 from transferring energy.

When the MCU 121 enables the balance circuit in response to a corresponding action to implement the parallel balance function between the sensory battery cells 100 , the MCUs 121 of the two sensing integrated circuits 120 control the switch S₅₂ to turn on, so that the capacitors C4 of the two sensing integrated circuits 120 are connected in parallel. The MCU 121 of the sensory battery cell 100 with a higher terminal voltage controls the switch S₅₁ to be turned on, so that the capacitor C4 is selectively connected in parallel to the sensory battery cell 100 to store electricity in the capacitor C4, and then the switch S₅₁ is turned off. Next, the MCU 121 of the sensory battery cell 100 with a lower terminal voltage controls the switch S₅₁ to turn on, so as to release the electric charge of the capacitor C4 to the sensory battery cell 100, and then turns off the switch S₅₁. Thus, when the plurality of sensory battery cells 100 are connected in parallel, the sensing integrated circuit 120 of the present invention can implement a parallel balance function between the one with higher energy storage and the one with lower energy storage.

Referring to FIG. 8B, there is shown a detailed circuit diagram of the function circuit 126 of the sensing integrated circuit 120 shown in FIG. 6B. For exemplary purpose, this embodiment is exemplified by four battery cells 1, but the present invention is not limited thereto. A plurality of battery cells 1 in parallel connection together forms a battery network, and the cathode of each battery cell 1 is a common terminal. According to the present invention, the sensory battery cells 100 have a cathode and an anode, with a plurality of charging and discharging electrical paths being formed between the cathode and the anode and corresponded to the battery cells 1, respectively. The sensing integrated circuit 120 comprises a function circuit 126 and a plurality of pins, wherein one of the pins is electrically connected to the anode, and at least a portion of the pins are electrically connected to the anodes of the battery cells 1, respectively. When a plurality of sensory battery cells 100 are in parallel connection, the common pins of the sensing integrated circuit 120 are electrically connected such that the sensory battery cells 100 in parallel connection can perform a parallel connection balance function. When the function circuit 126 is disabled, the switches S₁₁ to S₅₁ are turned OFF, preventing a capacitor C from transferring energy.

The function circuit 126 comprises a plurality of loop switches S₀₁ to S₀₄ and a power level balance circuit. The loop switches S₀₁ to S₀₄ are disposed on the charging and discharging electrical paths of the battery cells 1 respectively and adapted to disconnect or connect the charging and discharging electrical paths of the sensory battery cells 100, respectively. The power level balance circuit is controlled by the MCU 121 to perform a parallel connection power level balance between the battery cells 1 and a parallel connection power level balance between the sensory battery cells 100. In a variant embodiment of the present invention, the loop switches S₀₁ to S₀₄ are disposed between each of the battery cells 1 and the anode, as shown in FIG. 8B, or disposed between each of the battery cells 1 and the cathode, as shown in FIG. 8C. When the MCU 121 controllably causes the loop switches S₀₁ to S₀₄ to be turned OFF or turned ON according to an external instruction to allow the function circuit 126 to disconnect or connect the charging and discharging electrical path of each sensory battery cell 100 to selectively isolate at least one battery cell 1 or all battery cells 1 from executing charging or discharging, or adjust the battery network.

Referring to FIG. 8B, the operation of a parallel connection balance function for the battery cells 1, performed with the sensory battery cells 100 is described below. When the sensory battery cell 100 implements the parallel balance function of the battery cell 1, the switch S₅₁ is turned off. For example, among the two battery cells 1, the one with higher energy storage is V1 and the one with lower energy storage is V2. The MCU 121 of the sensing integrated circuit 120 first controls the loop switch S₀₁ to be turned off and the switch S₁₁ to be turned on, so that the one V1 with higher energy storage and the capacitor C are connected in parallel. After the capacitor C stores energy, the MCU 121 controls the loop switch S₀₁ to be turned on and the switch S₁₁ to be turned off. Afterwards, the MCU 121 controls the loop switch S₀₂ to be turned off and the switch S₂₁ to be turned on, so that the one V2 with lower energy storage is connected in parallel with the capacitor C. After the capacitor C releases energy to the one V2 with lower energy storage, the MCU 121 controls the loop switch S₀₂ to be turned on and the switch S₂₁ to be turned off. In this way, when a plurality of battery cells 1 are connected in parallel, the sensing integrated circuit 120 of the present invention can implement a parallel balance function between any two battery cells 1 with a higher energy storage and a lower energy storage.

Referring to FIG. 8B, the operation of a parallel connection balance function performed with the two sensory battery cells 100 is described below. To perform a parallel connection balance function of the sensory battery cells 100, the switches S₅₁ of their respective function circuits 126 turn on, allowing two capacitors C to be parallel-connected. For example, given a higher energy-storing sensory battery cell V1 in one sensory battery cell 100 and a lower energy-storing sensory battery cell V2 in another sensory battery cell 100, the MCU 121 of the sensing integrated circuit 120 of the higher energy-storing sensory battery cell V1 controllably causes the loop switch S₀₁ to turn off and the switch S₁₁ to turn on, allowing the higher energy-storing sensory battery cell V1 and two capacitors C to be parallel-connected. Thus, upon completion of energy-storing in the two capacitors C in parallel connection, the MCU 121 controllably causes the loop switch S₀₁ to turn on and the switch S₁₁ to turn off. After that, the MCU 121 of the sensing integrated circuit 120 of the lower energy-storing sensory battery cell V2 in the another sensory battery cell 100 controllably causes the loop switch S₀₂ to turn off and the switch S₂₁ to turn on, allowing the capacitors C in parallel connection and the lower energy-storing sensory battery cell V2 to be parallel-connected. Thus, after the two capacitors C in parallel connection have transferred energy to the lower energy-storing sensory battery cell V2, the MCU 121 controllably causes the loop switch S₀₂ to turn on and the switch S₂₁ to turn off. Therefore, when a plurality of sensory battery cells 100 are in parallel connection, the sensing integrated circuit 120 of the present invention can perform a parallel connection balance function between the higher energy-storing sensory battery cell and the lower energy-storing sensory battery cell.

The circuit diagram of the function circuit 126 and the plurality of battery cells 1 as shown in FIG. 8C is an equivalent circuit diagram of the function circuit 126 and the plurality of battery cells 1 as shown in FIG. 8B. The difference between the two circuit diagrams is as follows: the cathode of the plurality of battery cells 1 shown in FIG. 8B is a common terminal, whereas the anode of the plurality of battery cells 1 shown in FIG. 8C is a common terminal. Similarly, when a parallel connection balance function is performed by the two sensory battery cells 100, the common pins are electrically connected. When a parallel connection balance function of the plurality of battery cells 1 is performed by the two sensing integrated circuits 120, the MCU 121 controls the loop switches S₀₁ to S₀₄ and switches S₁₁ to S₅₁ in the same way.

Accordingly, the present invention provides a sensing integrated circuit and method thereof for accurately measuring the performance parameters of each battery cell, thereby evaluating the degradation or aging degree of each battery cell. The present invention provides a battery network and method thereof, which are adapted to build charging and discharging paths of a plurality of battery cells, adjust the battery network of an intelligent battery 500 based on the technical means of integrated circuits, and selectively isolate or rejoin at least one or part of the battery cells 1 for charging or discharging.

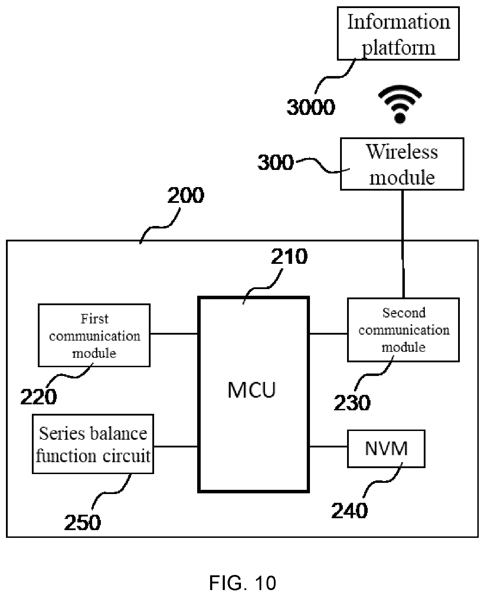

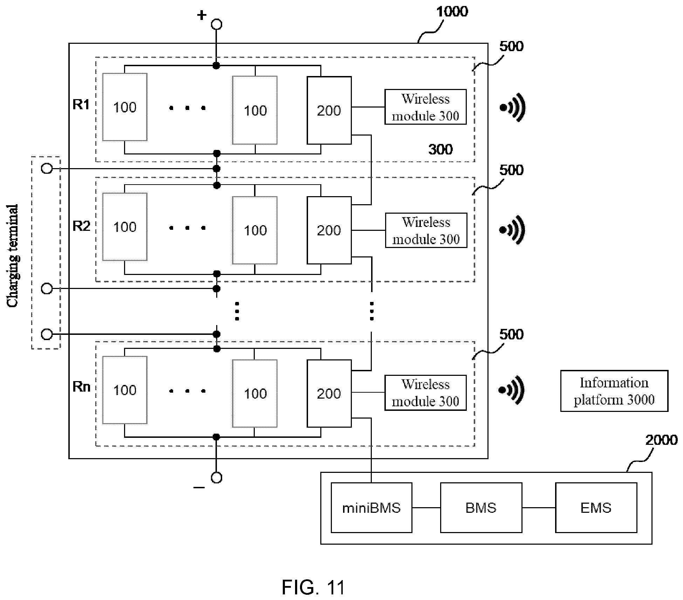

Referring to FIG. 10, there is shown a block diagram of a gateway integrated circuit 200. In an embodiment of the present invention, the gateway integrated circuit 200 comprises a microcontroller unit (MCU) 210, a first communication module 220, a second communication module 230, a non-volatile memory (NVM) 240 and a series balance function circuit 250. The first communication module 220 is controlled by the MCU 210 and adapted to communicate with the sensing integrated circuit 120 of each of the sensory battery cells 100 to receive the performance parameters of the battery cells of all the sensory battery cells 100 of an intelligent battery 500, as shown in FIG. 11. The second communication module 230 is controlled by the MCU 210 and adapted to carry out communication with an information platform 3000 through an external wireless module 300 or carry out communication with a battery management system (BMS) of the vehicular system 2000 through the series-connected gateway integrated circuit 200 of the intelligent battery 500 to send the performance parameters of the battery cells to the information platform 3000 or the battery management system. The vehicular system 2000 further includes an energy management system (EMS) and a small battery management system (miniBMS). The small battery management system collects battery information of the power battery 1000 and provides it to the energy management system of the vehicular system 2000 through the battery management system. The second communication module 230 is used to receive an external instruction regarding an aged battery cell, and transmit the external instruction to the sensing integrated circuit 120 of the sensory battery cell 100 including the aged battery cell through the first communication module 220, thereby causing the sensing integrated circuit 120 to implement a corresponding measure through the function circuit 126, wherein the external instruction comes from the information platform 3000.

In this embodiment of the present invention, the communication module 220 of the gateway integrated circuit 200 is directly connected to the communication module 124 of each sensing integrated circuit 120, allowing the gateway chip 200 to read the performance parameters of the battery cells by polling. In addition, the wireless module 300 is exemplified by a Bluetooth communication module.

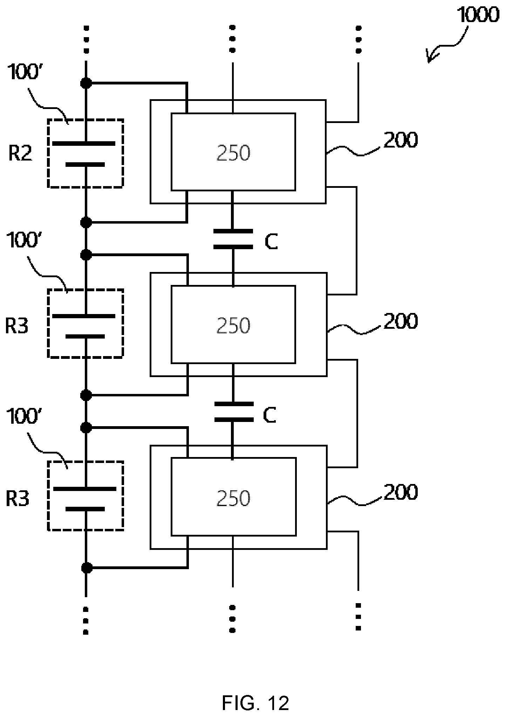

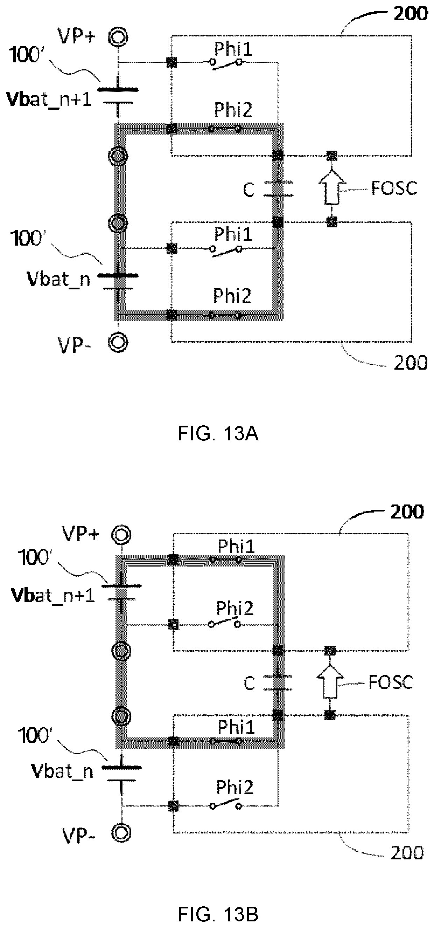

Furthermore, the NVM 240 stores a program code, including but not limited to the user serial number, the serial number of the intelligent battery 500, the serial number of each of the sensory battery cells 100, and their initial performance parameters. The MCU 210 executes the program code stored in the NVM 240 to perform all the functions and tasks designed to be carried out by the gateway integrated circuit 200 of the present invention. The series balance function circuit 250 is controlled by the MCU 210 and adapted to perform the power level balance between the intelligent batteries 500 in series connection, as shown in FIG. 12 and FIG. 13. The operation of the series balance function circuit 250 is further described below.

In a variant embodiment of the present invention, the gateway integrated circuit 200 enables the series balance function circuit 250 according to an external instruction to perform the power level balance between the intelligent batteries 500 in series connection or determines whether to start the series balance function circuit 250 according to a message sent from the series-connected gateway integrated circuits 200 of the intelligent battery 500. For instance, when a difference between the terminal voltages of the neighboring intelligent batteries 500 exceeds a predetermined value, the gateway integrated circuits 200 start and cause the series balance function circuit 250 to perform the power level balance.

In an embodiment of the present invention, the sensing integrated circuit precisely senses the charging and discharging states of the plurality of battery cells to synchronously measure the performance parameters of the battery cells, such as Vopen, charging current li and discharging current lo, charging internal resistance Ri and discharging internal resistance Ro, and battery temperature T, and the performance parameters are applied to the evaluation of the quality, health, service life and capacity of each of the battery cells, as further explained below.

### Evaluation of the quality of each battery cell

The sensing integrated circuit 120 accurately measures the Vopen, li/lo, and temperature T of each battery cell of a sensory battery cell, so that the Vopen difference ΔVopen and the internal resistance Ri/Ro of each battery cell associated with the temperature T can be calculated and collected for statistics, wherein the internal resistance Ri is the internal resistance of the battery cell when charging, and the internal resistance Ro is the internal resistance of the battery cell when discharging. The information platform 3000 of the present invention evaluates the quality of each battery cell based on the average and standard deviation of the performance parameters of all battery cells of a power battery, finds out the battery cells whose performance parameters fall outside the standard deviation and takes a corresponding action.

As exemplified in FIG. 8A, when the balance circuit of the function circuit 126 is disabled, the MCU 121 controls the circuit switch S₀₀ to temporarily cut off the charging circuit or the discharging circuit of the battery cells, and during the circuit cutting period, the MCU 121 controls the battery measurement circuit 122 to measure the open circuit voltage Vopen of each battery cell 1 associated with temperature T, so as to calculate the Vopen difference ΔVopen of each battery cell associated with temperature T, so as to evaluate the quality of the battery cell compared to the initial startup state. During the period when the MCU121 controls the loop switch S₀₀ to turn on the charging loop or the discharging loop of the battery cells, the MCU121 controls the battery measurement circuit 122 and the current measurement circuit 123 to measure the terminal voltage Vbat and the charging or discharging current Ibat associated with the temperature T for each battery cell 1, wherein the charging or discharging current Ibat is calculated based on the terminal voltage and the on-resistance of the loop switch S₀₀. Therefore, the MCU 121 of the sensing integrated circuit 120 can calculate the internal resistance Rbat of each battery cell 1 associated with the temperature T. The specific calculation formula is Rbat=(Vbat-Vopen)/Ibat.

As exemplified in FIG. 8B and FIG. 8C, when the balance circuit of the function circuit 126 is disabled, the MCU 121 controls all the circuit switches S₀₁ to S₀₄ to temporarily cut off the charging circuit or the discharging circuit of each battery cell 1, and during the circuit cutting period, the MCU 121 controls the battery measurement circuit 122 to measure the open circuit voltage Vopen of each battery cell 1 at the associated temperature T, so as to calculate the Vopen difference ΔVopen of each battery cell associated with temperature T, so as to evaluate the quality of the battery cell compared to the initial startup state. During the period when the MCU121 controls the loop switches S₀₁ to S₀₄ to turn on the charging loop or the discharging loop of the battery cells, the MCU121 controls the battery measurement circuit 122 and the current measurement circuit 123 to measure the terminal voltage Vbat and the charging or discharging current Ibat associated with the temperature T for each battery cell 1, wherein the charging or discharging current Ibat is calculated based on the terminal voltage and the resistance of each loop switch S₀₁ to S₀₄. Therefore, the MCU 121 of the sensing integrated circuit 120 can calculate the internal resistance Rbat of each battery cell 1 associated with the temperature T. The specific calculation formula is Rbat=(Vbat-Vopen)/Ibat.

### Evaluation of the health or service life of each battery cell

The sensing integrated circuit accurately measures the Vopen, li/lo, and temperature T of each battery cell of a sensory battery cell, so that the charge and discharge state of each battery cell at the initial use associated with temperature T, including but not limited to Vopen, difference ΔVopen, charge and discharge current li/lo, and internal resistance Ri/Ro, can be recorded and saved, and compared with the charge and discharge state associated with temperature T after long-term use to obtain the performance parameter difference of the charge and discharge state. Therefore, the information platform 3000 of the present invention evaluates the health or life of each battery cell according to the difference in the charge and discharge state of the battery cell at the initial use and after long-term use.

### Evaluation of the capacity of each battery cell

According to Q=IT=CV, where T denotes time, the embodiment of the present invention precisely measures the temperature-associated Vopen by the sensing integrated circuits, difference ΔVopen, li/lo of each battery cell to measure and evaluate the charging and discharging capacitance (SOC) of the battery cells according to Vopen or ΔVopen, with IiT or IoT being a constant value.

According to the aforesaid embodiments of the present invention, the present invention provides aspects as follows.

The present invention provides a battery power level management method adapted to manage charging or discharging for at least one sensory battery cell. The sensory battery cell comprises a plurality of battery cells and a sensing integrated circuit. The sensing integrated circuit connects the battery cells in parallel. The battery power level management method comprises the steps of: measuring, by the sensing integrated circuit, performance parameters of the battery cells, the performance parameters including but not limited to Vopen associated with battery temperature, charging and discharging internal resistance, charging and discharging number, and a result of measurement; receiving and sending, by a gateway integrated circuit, the performance parameters of the battery cells, to a battery management system; receiving, by the gateway integrated circuit, from the battery management system an instruction, wherein the instruction indicates a degraded one of a plurality of battery cells; and instructing, by the gateway integrated circuit, the sensing integrated circuit parallel-connecting to the degraded battery cell to take an action against the degraded battery cell, wherein the action includes but is not limited to isolating the sensory battery cell from performing charging and discharging, performing power level balance to the degraded battery cell, or a combination thereof.

The present invention provides a gateway integrated circuit, adapted to send performance parameters of a plurality of battery cells, comprises a first communication module, a second communication module and an MCU, wherein the MCU electrically connected to the first communication module and the second communication module. The MCU controls the first communication module to receive performance parameters of a plurality of battery cells from at least one sensing integrated circuit, wherein the sensing integrated circuit measures the performance parameters of the battery cell. The MCU controls the second communication module to transmit the performance parameters of the battery cells to a battery management system, and the battery management system is used to evaluate a degraded battery cell among the plurality of battery cells.

The present invention provides a sensing integrated circuit, adapted to sense a plurality of battery cells, comprises a plurality of pins, at least one battery measurement circuit, a function circuit and an MCU. A portion of the plurality of pins connects the battery cells in parallel. The battery measurement circuit electrically connected to the portion of the pins to measure Vopen of each of the battery cells. The function circuit electrically connected to a plurality of battery cells via a portion of the plurality of pins to take an action. The MCU electrically connected to the battery measurement circuit measure performance parameters of each battery cell and send the performance parameters of the battery cells to a gateway integrated circuit, wherein the MCU controllably causes the function circuit to take an action against a degraded one of a plurality of battery cells, and the action comprises isolating the sensory battery cell from executing charging and discharging, performing power level balance on the degraded battery cell, or a combination thereof.

The present invention provides a sensory battery cell which comprises a plurality of battery cells and a sensing integrated circuit. The plurality of battery cells has a battery network, the battery network is a series connection network or a parallel connection network. The sensing integrated circuit comprises a plurality of pins and a function circuit, wherein a portion of the pins connects the battery cells in parallel form, and the function circuit electrically connects to the plurality of battery cells via the portion of the pins. Wherein the sensing integrated circuit measures performance parameters of each of the battery cells, the performance parameters are used for evaluating a degradation degree of each of the battery cells. The sensing integrated circuit controllably causes the function circuit to take an action against the battery cells whose degradation degree meets a setting criterion, wherein the action includes, but not limited to, isolating charging and discharging, power level balance, or a combination thereof.

The present invention provides an intelligent battery which comprises a plurality of sensory battery cells and at least one gateway integrated circuit. The intelligent battery has a first battery network. Each sensory battery cell comprises a plurality of battery cells and has a second battery network. Each sensory battery cell comprises a sensing integrated circuit which is connected in parallel with each battery cell to measure the performance parameters of each battery cell. The gateway integrated circuit is electrically connected to the plurality of sensory battery cells. The gateway integrated circuit communicates with the sensing integrated circuit of each sensory battery cell to receive the performance parameters of each battery cell and transmit the performance parameters of each battery cell to a battery management system or an information platform.

The present invention provides a power battery which comprises a plurality of battery cells and a plurality of sensing integrated circuits. The plurality of battery cells is arranged in a battery network, the battery network is selected from a group of a series connection network, a parallel connection network, a series-parallel network and a parallel-series network to perform charging or discharging. Each sensing integrated circuit parallelly connects to at least one of the battery cells or some of the battery cells in series connection or parallel connection to measure performance parameters of each of the battery cells, the performance parameters are used for evaluating a degradation degree of each of the battery cells. When the degradation degree of one of the battery cells meets a setting criterion, the sensing integrated circuit parallel-connecting to the battery cell meeting the setting criterion takes an action against the battery cell meeting the setting criterion.

The power battery further comprises at least one gateway integrated circuit which sends the performance parameters of each of the battery cells to a battery management system to allow the battery management system to evaluate whether the degradation degree of each of the battery cells meets the setting criterion according to the performance parameters of each of the battery cells and thereby send a management instruction reply to the gateway integrated circuit.

Referring to FIG. 11, there is shown a block diagram of a power battery 1000 of the present invention. In an embodiment of the present invention, the power battery 1000 comprises a plurality of intelligent batteries 500. The intelligent batteries 500 are arranged in a series connection network to perform charging or discharging. Each intelligent batterie 500 comprises a plurality of sensory battery cells 100 and a gateway integrated circuit 200. The sensory battery cells 100 are arranged in a parallel connection network or a series connection network. The gateway integrated circuit 200 is electrically connected to each of the sensory battery cells 100. The neighboring gateway integrated circuits 200 of the series-connected intelligent batteries 500 can communicate with each other. Each of the sensory battery cells 100 comprises a plurality of battery cells 1 and a sensing integrated circuit 120, as shown in FIG. 6A or FIG. 6B. The sensing integrated circuit 120 senses the temperature T of each of the battery cells 1 and measures the performance parameters of each of the battery cells 1. The performance parameters include but are not limited to open-circuit voltage (Vopen) associated with battery temperature, open-circuit voltage difference (ΔVopen), charging and discharging current, charging and discharging internal resistance, charging and discharging number or a result calculated according to the aforesaid parameters or measurement values. The gateway integrated circuit 200 communicates with the sensing integrated circuit 120 to receive the performance parameters of the battery cells 1 of the intelligent batteries 500. In a further embodiment of the present invention, the gateway integrated circuit 200 sends the performance parameters of the battery cells 1 to a battery management system of a vehicular system 2000 or an information platform 3000 to evaluate a degraded one of the plurality of battery cells.

When the sensory battery cell 100 is composed of a plurality of battery cells 1 and a sensing integrated circuit 120, the manufacturing serial numbers of the battery cells 1 are written into the NVM 125 of the sensing integrated circuit 120, and each sensory battery cell 100 is given a unique serial number to be written into the NVM 125. When the intelligent batterie 500 is composed of a plurality of sensory battery cells 100 and a gateway integrated circuit 200, the serial numbers of the sensory battery cells 100 are written into the NVM 240 of the gateway integrated circuit 200, and the intelligent batterie 500 is given a unique serial number to be written into the NVM 240. The power battery 1000 comprises a plurality of intelligent batteries 500 in series connection to form a battery network, and the power battery 1000 is also given a unique serial number to be written into the NVMs 240 of the gateway integrated circuits 200. The battery network can be equivalent to a plurality of connected intelligent batteries 500, equivalent to a plurality of connected sensory battery cells 100, or equivalent to a plurality of connected battery cells 1. The battery network records deployment of the intelligent batteries 500, the sensory battery cells 100, and the battery cells 1 in the battery network. The serial numbers and the battery network become a portion of the battery course of the power battery 1000. If the power battery 1000 is assigned to a user, a user serial number of the user will also be written into the NVM 125 of the sensing integrated circuits 120 and the NVMs 240 of the gateway integrated circuits 200. The replacement of the constituent units (including the intelligent batteries, sensory battery cells and battery cells) of the power battery 1000 requires the information platform to obtain an authorization and consent from a verified mobile device of the user. The serial numbers of the power battery 1000 of the user, the battery network, and the initial performance parameters of the battery cells 1 are uploaded to the battery history-related information management system of the present invention, for example, the vehicular system 2000 or the information platform 3000 shown in FIG. 11. The battery history-related information management system collects the performance parameters of each of the battery cells 1 in the course of the usage of the power battery 1000 to create a plurality of time-related point data of battery history to allow the power battery 1000 to have battery history that can be tracked and examined and ensures a good second-hand price of the power battery 1000. Data of each time point records the performance parameters of each battery cell of the power battery with a timestamp.

In another embodiment of the present invention, a power battery 1000 comprises a plurality of intelligent batteries 500 arranged in a series connection network to perform charging or discharging. The intelligent batteries 500 in series connection define a cathode and an anode. An external power supply system (not shown) enables the rated capacity charging of the power battery 1000 through the cathode and the anode. Furthermore, the power battery 1000 provides a charging terminal between at least one pair of intelligent batteries 500 in series connection. When another external power supply system (not shown) cannot enable the rated capacity charging of the power battery 1000, the other external power supply system performs the charging on at least one of, or a portion of, the intelligent batteries 500 of the power battery 1000 according to maximum output power through the charging terminal. The gateway integrated circuits 200 of neighboring intelligent batteries 500 in series connection can communicate with each other, the other intelligent batteries 500 uncharged can cause the series balance function circuit 250 to perform power level balance between the intelligent batteries 500 charged and the intelligent batteries 500 uncharged, as shown in FIG. 10.

FIG. 12 and FIG. 13A to FIG. 13B depict how the gateway integrated circuits 200 start an operation of the series balance function circuits 250. FIG. 12 is a partial equivalent circuit diagram of the power battery 1000 shown in FIG. 11. The equivalent battery 100' is an equivalent battery of a plurality of sensory battery cells 100. FIG. 13A and FIG. 13B respectively illustrate a detailed circuit diagram of the series balance function circuit 250 in operation. In an embodiment of the present invention, to balance the power level between the intelligent batteries 500 in series connection, an external capacitor C is disposed between the gateway integrated circuits 200 to transfer energy between the intelligent batteries 500. The gateway integrated circuit 200 includes a series balance function circuit 250 which is used to store energy in at least one balancing capacitor C of the battery cells of the smart battery 500, or to release energy from at least one balancing capacitor C to the battery cells of the smart battery 500. When the series balance function is not started, switches Phi1, Phi2 of the series balance function circuit 250 turn OFF, preventing the external capacitor C from transferring energy. Thus, the two gateway integrated circuits 200 can communicate with each other upward and downward. For example, when an equivalent battery Vbat_n stores more energy than an equivalent battery Vbat_n+1, the two gateway integrated circuits 200 controllably cause the switches Phi1 to turn ON and the switches Phi2 to turn OFF, forming parallel connection of the equivalent battery Vbat_n and external capacitor C, as shown in FIG. 13A. After the external capacitor C has finished storing energy, the two gateway integrated circuits 200 controllably cause the switches Phi1 to turn OFF and the switches Phi2 to turn ON to form parallel connection of the equivalent battery Vbat_n+1 and external capacitor C, as shown in FIG. 13B, allowing the external capacitor C to transmit energy to the equivalent battery Vbat_n+1. When the equivalent battery Vbat_n+1 stores more energy than the equivalent battery Vbat_n, the two gateway integrated circuits 200 control the switches Phi1, Phi2 to allow the equivalent battery Vbat_n+1 to be parallel-connected to the external capacitor C and then allow the external capacitor C to be parallel-connected to the equivalent battery Vbat_n, allowing the higher energy-storing battery cell to transfer energy to the lower energy-storing battery cell via the external capacitor C.

In a variant embodiment of the present invention, when the gateway integrated circuits 200 collect the performance parameters of the battery cells of the sensory battery cells 100 of the intelligent batteries 500, the gateway integrated circuits 200 send the performance parameters to a verified user terminal (not shown) or the information platform 3000 of a computer through the second communication module 230 and a wireless module 300, or send the performance parameters to a battery management system of the vehicular system 2000 through the two gateway integrated circuits 200 communicating with each other.

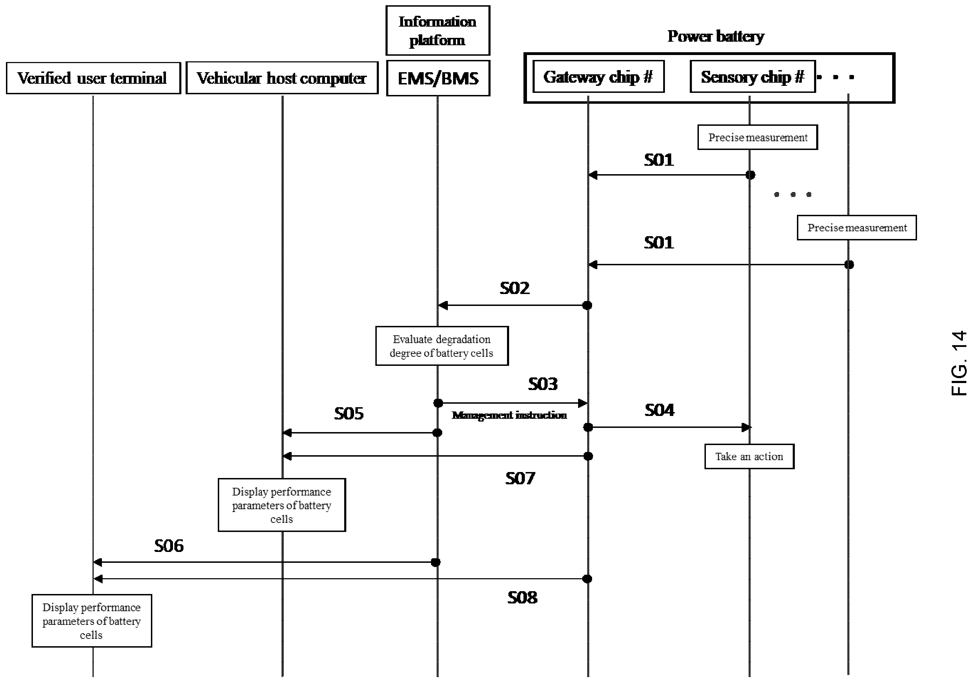

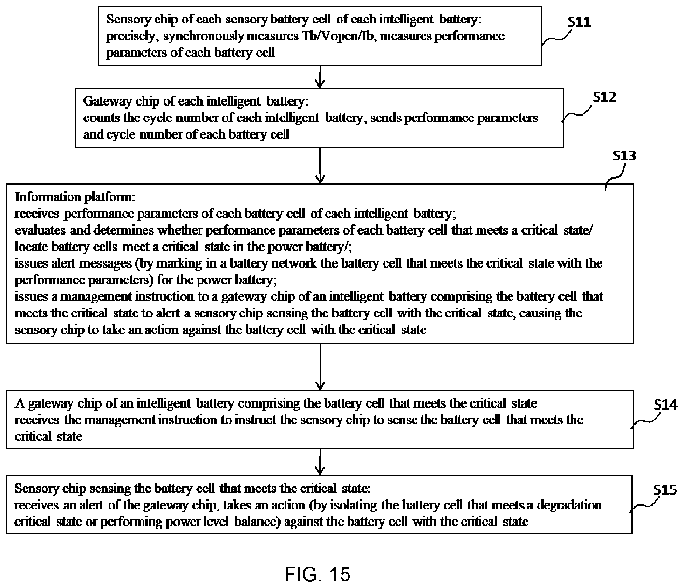

FIG. 14 and FIG. 15 which respectively show a message sequence chart and a method flow chart of the battery management system of the present invention. In one embodiment of the present invention, a battery management system is used to manage the charging and discharging of a power battery. The power battery comprises a plurality of intelligent batteries, each of which comprises at least one gateway integrated circuit and a plurality of sensory battery cells. Each sensory battery cell includes a sensing integrated circuit and a plurality of battery cells. All battery cells contained in the power battery are charged and discharged through a battery network. The battery management system of the present invention includes an information platform, which is established on a cloud server system or a vehicular battery management system.

The battery management system of the present invention implements the battery management method shown in FIG. 15. In step S11, the sensing integrated circuit of each sensory battery cell of each intelligent battery accurately and synchronously measures the temperature, open circuit voltage and charge and discharge current of each battery cell, thereby measuring performance parameters of each battery cell. The performance parameters include, but are not limited to, the open circuit voltage difference (ΔVopen) associated with the battery temperature, the internal resistance of charge and discharge.

Next, in step S12, the gateway integrated circuit of each intelligent battery counts the cycle number of the intelligent battery, receives the performance parameters of each battery cell by polling (i.e. message S01 in FIG. 14), and transmits the performance parameters and the cycle numbers of all battery cells of the power battery to the information platform (i.e. message S02 in FIG. 14).

In step S13, the information platform receives the performance parameters of each battery cell of each intelligent battery of the power battery. The information platform evaluates whether the performance parameters of each battery cell reach a critical state to find out the battery cells in the power battery that have reached a critical state, and the critical state defines the degree of degradation of a battery cell. When the power battery includes a battery cell that has reached the critical state, the information platform notifies the user of a warning message about the power battery and, if necessary, displays a battery network of the power battery on the vehicle host or user authenticated terminal (i.e. messages S05 and S06 in FIG. 14) to indicate the position of the battery cell that has reached the critical state and its performance parameters. The information platform issues a management instruction to the gateway integrated circuit of the intelligent battery including the battery cell that has reached the critical state (i.e. message S03 in FIG. 14), and then notifies the sensing integrated circuit that senses the battery cell that has reached the critical state (i.e. message S04 in FIG. 14), so that the sensing integrated circuit takes a corresponding action against the battery cell that has reached the critical state.

In step S14, the gateway integrated circuit of the intelligent battery including the battery cell that has reached the critical state receives the management instruction from the information platform (i.e. message S03 in FIG. 14), and accordingly notifies the sensing integrated circuit that senses the battery cell that has reached the critical state (message S04 in FIG. 14 ).

Step S15, receiving the notification from the gateway integrated circuit, enabling a function circuit to take a corresponding action against the battery cell that has reached the critical state, the corresponding action includes, but is not limited to, temporarily or selectively isolating the battery cell that has reached the critical state, or implementing power balancing.

In addition, in different embodiments of the present invention, after the gateway integrated circuit of the intelligent battery receives the performance parameters of each battery cell, the gateway integrated circuit can further transmit the performance parameters to the vehicle host or user authenticated terminal (i.e. messages S07 and S08) and display a battery network of the power battery or its equivalent circuit, so that the user can see the real-time status of the power battery, intelligent battery, and sensor battery cell, such as the remaining power or battery quality.

According to the aforesaid embodiments of the present invention, the present invention further provides aspects as follows.

The present invention provides a battery management method, adapted to manage charging or discharging of a power battery 1000. The power battery 1000 comprises a plurality of battery cells 1 arranged in a battery network (being one of a series connection network, a parallel connection network, a series-parallel network and a parallel-series network as shown in FIG. 1 or FIG. 3), wherein at least one battery cell or some of the battery cells in series or parallel connection is/are parallel-connected to a sensing integrated circuit 120. The sensing integrated circuit 120 measures performance parameters (including but not limited to Vopen associated with battery temperature, ΔVopen, charging and discharging internal resistance, charging and discharging times) of each battery cell. The battery management method comprises the steps of: obtaining, from a plurality of sensing integrated circuits 120, performance parameters of each battery cell 1 of the power battery 1000; evaluating and determining whether the performance parameters of each battery cell 1 meet a critical state, wherein the critical state defines degradation degree of a battery cell; and issuing a management instruction to the sensing integrated circuit 120 parallel-connected to the battery cell that meets the critical state to cause the sensing integrated circuit 120 to take an action against the battery cell with the critical state. The action includes but not limited to temporarily or selectively isolate the battery cell that meets the critical state from the battery network, or performing power level balance on the battery cell that meets the critical state.

The present invention provides a battery management system which comprises a plurality of battery cells 1, a plurality of sensing integrated circuits 120 and an information platform 3000. The plurality of battery cells 1 is arranged in a battery network (being one of a series connection network, a parallel connection network, a series-parallel network and a parallel-series network as shown in FIG. 1 or FIG. 3) to perform charging or discharging. Each sensing integrated circuit 120 is parallel-connected to at least one battery cell 1 or some of the battery cells 1 in series connection or parallel connection to measure performance parameters (including but not limited to Vopen, ΔVopen associated with battery temperature, charging and discharging internal resistance, charging and discharging number) of each of the battery cells. The information platform 3000 collects the performance parameters of each of the battery cells and evaluates and determines whether the performance parameters of each of the battery cells meet a critical state. Wherein the plurality of sensing integrated circuits 120 send the performance parameters of each of the battery cells to the battery performance evaluation unit, and the battery performance evaluation unit identifies whether the battery cell that meets the critical state in the power battery 1000.

When the battery performance evaluation unit determines that a battery cell in the power battery 1000 has reached the critical state, it will issue a management instruction to the sensing integrated circuit 120 connected in parallel with the battery cell that has reached the critical state. The sensing integrated circuit 120 connected in parallel to the battery cell that has reached the critical state activates a function circuit FC to take a corresponding action against the battery cell that has reached the critical state. The corresponding action includes, but are not limited to, temporarily or selectively isolating the battery cells that have reached the critical state from the battery network or performing power balancing on the battery cells that have reached the critical state.

The present invention provides a battery degradation management method, adapted to manage at least one degraded battery cell of a power battery 1000. The power battery 1000 comprises a plurality of battery cells 1 and a plurality of sensing integrated circuits 120, the battery cells are arranged in a battery network (being one of a series connection network, a parallel connection network, a series-parallel network and a parallel-series network) to perform charging or discharging, the sensing integrated circuit 120 senses each of the battery cells 1 to measure performance parameters (e.g. charging and discharging internal resistance and ΔVopen associated with battery temperature) of each of the battery cells. The battery degradation management method comprises the steps of: obtaining the performance parameters of each of the battery cells of the power battery 1000 from the plurality of sensing integrated circuit 120; evaluating and determining whether each of the battery cells meets a degradation critical state; issuing a management instruction to the sensing integrated circuit 120 parallel-connected to the battery cell that meets the degradation critical state to cause the sensing integrated circuit 120 to take an action against the battery cell that meets the degradation critical state. The critical state of degradation is that the internal resistance accurately measured by the method of the present invention is 3% or 5% higher than the internal resistance in the initial state or a preset threshold, or the battery capacity accurately measured by the method of the present invention is 5% or 10% lower than the battery capacity in the initial state or a preset threshold, or the difference between the battery parameters accurately measured by the method of the present invention and the battery parameters in the initial state reaches a preset threshold.

The present invention provides a battery degradation management system which comprises a power battery 1000 and a plurality of sensing integrated circuits 120. The power battery 1000 comprises a plurality of battery cells 1 arranged in a battery network (being one of a series connection network, a parallel connection network, a series-parallel network and a parallel-series network) to perform charging or discharging. The plurality of sensing integrated circuits 120 configured for sensing each of the battery cells to measure performance parameters (e.g. charging and discharging internal resistance and ΔVopen associated with battery temperature) of each of the battery cells. The plurality of sensing integrated circuits 120 send the performance parameters of each of the battery cells to an information platform 3000. The information platform 3000 evaluates and determines whether the performance parameters of each of the battery cells meets a degradation critical state. When a battery cell of the power battery 1000 reaches the critical state of degradation, the sensing integrated circuit 120 connected in parallel to the battery cell that reaches the critical state of degradation receives a management instruction to take a corresponding action against the battery cell that reaches the critical state of degradation.

The present invention provides a battery history-related information management system, adapted to manage battery history of a power battery. The power battery 1000 comprises a plurality of battery cells 1 and a plurality of sensing integrated circuits 120, wherein the battery cells are charged or discharged via a battery network as shown in FIG. 1 or FIG. 3, and the plurality of sensing integrated circuits 120 measures and transmits the performance parameters of each battery cell. The information system comprises an information platform recording the battery network of the power battery, assigning a unique serial number for the power battery, recording position information of each of the battery cells in the battery network, recording a serial number of each of the battery cells, recording a user serial number to which the power battery 1000 is assigned, collecting performance parameters of each of the battery cells after the power battery 1000 is assigned to the user serial number to create a battery course of the power battery, the battery course has data of several time points, wherein the data records the performance parameters, with a timestamp, of each of the battery cells of the power battery 1000 at the several time points.

The information platform 3000 is built on a cloud server system or a vehicular battery management system. When the power battery 1000 changes at least one of the battery cells 1, the information platform 3000 has to accept the authorization and consent from a verified mobile device associated with the user serial number. Therefore, the battery history of the power battery 1000 can be tracked and inspected.

The present invention provides a battery degradation management method, adapted to manage at least one sensory battery cell 100 in parallel connection, each sensory battery cell 100 comprises at least one battery cell 1 and a sensing integrated circuit 120, the sensing integrated circuit 120 is parallel-connected to at least one battery cell 1 or a plurality of battery cells 1 in series connection or parallel connection to measure performance parameters (e.g. ΔVopen, charging internal resistance and discharging internal resistance associated with battery temperature) of each of the battery cells 1. The battery degradation management method comprises the steps of: obtaining the performance parameters of the battery cell 1 of the sensory battery cell 100 from the sensing integrated circuit 120 of the sensory battery cell 100; sending the performance parameters of the battery cell 1 to an information platform 3000, the information platform 3000 evaluating and determining whether the performance parameters of the battery cell meets a degradation critical state; receiving from the information platform 3000 a management instruction for instructing the sensing integrated circuit 120 of the sensory battery cell 100 to take an action (e.g. isolating selectively the battery cell that meets the degradation critical state from a battery network or performing power level balance on the battery cell that meets the degradation critical state) against the battery cell that meets the degradation critical state.

The present invention provides a power battery 1000 which comprises a plurality of sensory battery cells 100 and a plurality of gateway integrated circuits 200. The plurality of sensory battery cells 100 is arranged in a battery network (being one of a series connection network, a parallel connection network, a series-parallel network and a parallel-series network) to perform charging or discharging, each of the sensory battery cells 100 comprises a plurality of battery cells 1 in series connection or parallel connection and a sensing integrated circuit 120, the sensing integrated circuit 120 is parallel-connected to at least one of the battery cells 1 or some of the battery cells 1 in series connection or parallel connection, so as to measure the performance parameters (e.g. charging internal resistance, discharging internal resistance, and ΔVopen associated with battery temperature) of each battery cell. Each gateway integrated circuit 200 is parallel-connected to at least one sensory battery cell 100 to obtain the performance parameters of each battery cell of the sensory battery cell 100 from the sensing integrated circuit 120. Each of the gateway integrated circuits 120 sends the performance parameters of the battery cells to an information platform 3000 such that the information platform 3000 evaluates and determines whether the performance parameters of each battery cell meet a degradation critical state. When one of the gateway integrated circuits 200 receives a management instruction from the information platform 3000, the gateway integrated circuit 200 notifies the sensing integrated circuit 120 of the sensory battery cell 100 to take a corresponding action against the battery cell that has reached the critical degradation state.

In an embodiment of the present invention, for example, one single battery cell has a voltage of 3.68V and a capacity of 66Ah. Given the sensory battery cell 100, intelligent battery 500, power battery 1000, and battery management system and method according to the present invention, if a sensory battery cell 100 comprises four battery cells as shown in FIG. 8A, the sensory battery cell will have a voltage of 14.72V and a capacity of 66Ah, and the sensory battery cell shown in FIG. 8B will have a voltage of 3.68V and a capacity of 264Ah, and each sensory battery cell 100 will have a capacity of 971.52Wh. As shown in FIG. 8A, if three sensory battery cells 100 are parallel-connected to form one intelligent battery 500, and then 27 intelligent batteries 500 are series-connected to form a power battery 1000, the intelligent batteries 500 will have a voltage of 14.72V and a capacity of 198Ah, and the power battery 1000 will have a voltage of 397.44V and a capacity of 198Ah.

Therefore, if in an initial state a new power battery 1000 has battery cells which demonstrate quality consistency, the power battery 1000 will provide a rated capacity of 78.7kWh. Given the battery management system and method according to the present invention, the longer the quality consistency of the battery cells lasts, the greater the mileage of electric vehicle using the power battery 1000 can be obtained with the aforesaid performance parameters. In an embodiment of the present invention, in the initial stage of usage, the performance parameters of the power battery 1000 and its battery cells are recorded on an information platform 3000, or the performance parameters related to battery cells provided by battery suppliers are recorded on the information platform 3000, allowing each battery cell to be evaluated and determined whether it meets a degradation degree or a setting criterion. After the information platform 3000 has collected the performance parameters of each battery cell of the power battery 1000 for a period of time, the information platform 3000 creates data at several time points during a battery course to allow the power battery to have a battery history that can be tracked and examined, ensuring a good second-hand price of the power battery. If it is evaluated and determined that the degradation degree of one of the battery cells meets a setting criterion, the information platform 3000 will issue a management instruction to the sensing integrated circuit 120 parallel-connected to the battery cell that meets the setting criterion to take an action against the battery cell that meets the setting criterion.

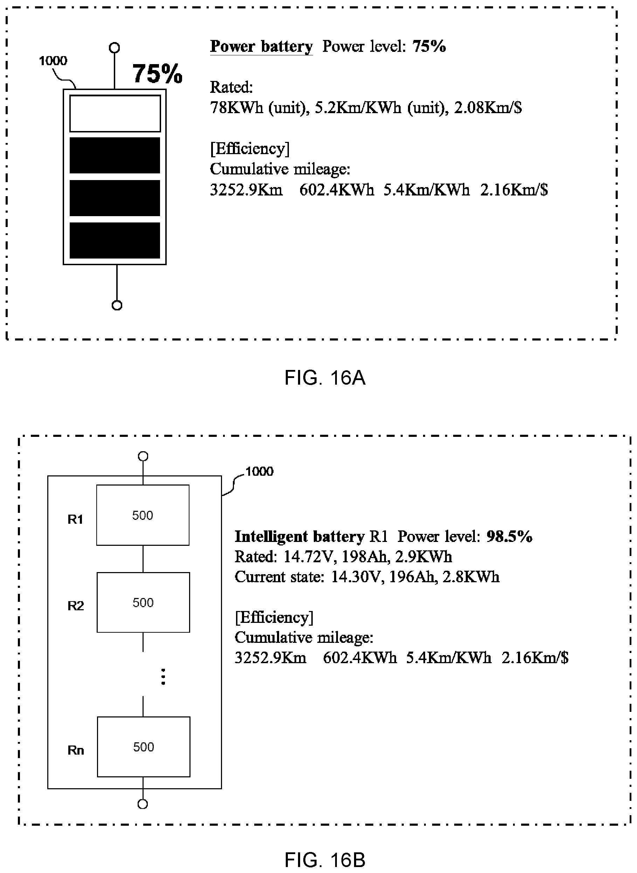

The information platform 3000 can send an alert message associated with the power battery 1000 to the user as needed and display a battery network of the power battery 1000 on a vehicular host computer or a verified user terminal, as described in messages S05 and S06 shown in FIG. 14. In an embodiment of the present invention, the power battery 1000 is exemplified by an equivalent battery, wherein the power level and capacity of the equivalent battery can be measured according to the power level and capacity of all the battery cells. Referring to FIG. 16A, there is shown a schematic view of a battery state of the power battery 1000 of the present invention. For instance, on the display screen, an equivalent battery not only shows that the power battery 1000 has a residual power level of 75% and is rated 78KWh, but also shows that the power battery 1000 enables a travel distance of 5.2 km per KWh as measured according to electric vehicles using the power battery, and even the electric bill of the power battery is measured to be a travel distance of 2.08 km per dollar. Furthermore, the display screen further displays the driving efficiency of electric vehicles.

In another embodiment of the present invention, the power battery 1000 is expressed in the form of a series connection network comprising a plurality of intelligent batteries 500. The power level and capacity of each of the intelligent batteries 500 can be measured according to the power level and capacity of all the battery cells. As shown in FIG. 16B, there is shown a schematic view of another battery state of the power battery 1000 of the present invention. For example, the user can select to display information of one of the intelligent batteries 500 on the touch screen, such as the rated data is 14.72V, 198Ah, and 2.9KWh, and the current status is 14.30V, 196Ah, and 2.8KWh.

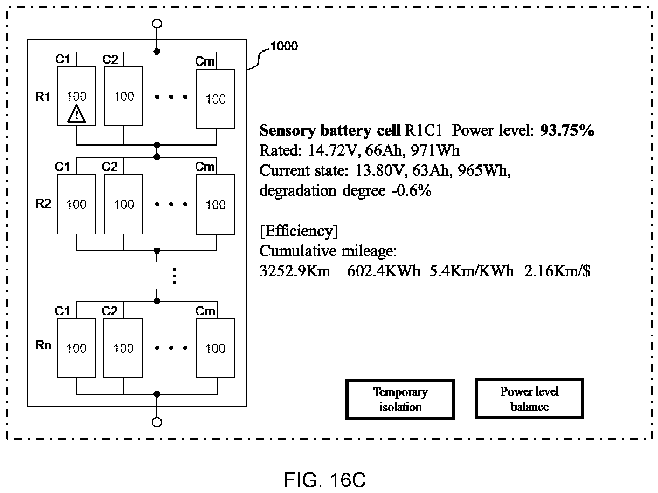

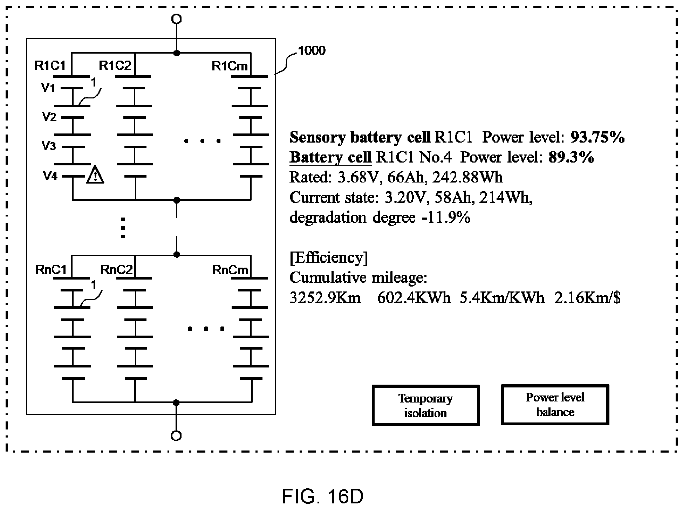

In another embodiment of the present invention, the power battery 1000 is expressed in the form of a battery network comprising a plurality of sensory battery cells 100 or battery cells, the power level and capacity of each sensory battery cell 100 are measured according to the power level and capacity of all the battery cells. FIG. 16C and FIG. 16D are schematic views showing battery status display of the power battery 1000 of the present invention using a plurality of sensing battery cells 100 and a plurality of battery cells 1 respectively.

For instance, when the information platform 3000 evaluates and determines that the degradation degree of one of the battery cells meets a setting criterion, the information platform 3000 provides related information associated with the power battery 1000 to a vehicular host computer or a verified user terminal, as displayed on the display screens shown in FIG. 16C and FIG. 16D. As shown on the display screens, in the battery network of the power battery 1000, position R1C1 and alert symbol of the battery cells (of the sensory battery cells 100) meeting the setting criterion are marked as shown in FIG. 16C, or position R1C1 No.4 and alert symbol of the battery cells meeting the setting criterion are marked as shown in FIG. 16D. The alert symbol is a triangle that contains an exclamation mark.

On the display screen shown in FIG. 16C, the sensory battery cell 100 at position R1C1 has a residual power level of 93.75% and rated 14.72V, 66Ah, 971Wh. The sensory battery cell 100 comprises battery cells that meet the setting criterion. Thus, after performing rated charging, the sensory battery cell 100 has a current state of 13.80V, 63Ah, 869Wh, and the degradation degree of the sensory battery cell 100 is evaluated and determined to be -0.6%. On the display screen shown in FIG. 16D, the sensory battery cell 100 at position R1C1 has a residual power level of 93.75%, whereas the battery cell at position R1C1 No.4 has a residual power level of 89.3% and rated 3.68V, 66Ah, 242.88Wh. Performance parameter of the battery cell at position R1C1 No.4 meets the setting criterion; thus, after the sensory battery cell 100 has performed rated charging, the battery cell at position R1C1 No.4 has a current state of 3.20V, 58Ah, 214Wh, and the degradation degree of the battery cell is evaluated and determined to be -11.9%.

Referring to the display screens shown in FIG. 16C and FIG. 16D, when the user notes that the information platform 3000 has a mark indicating that a specific sensory battery cell 100 or battery cell at a position of the power battery 1000 exhibits an alert degradation degree, the user can press the "temporary isolation" button or "power level balance" button on the display screens to cause the information platform 3000 to issue a management instruction to a gateway integrated circuit 200 of an intelligent battery 500 or a sensing integrated circuit 120 of a sensory battery cell 100, which meets a setting criterion, thereby causing the sensing integrated circuit 120 to take an action against the battery cell that meets the setting criterion. In a variant embodiment of the present invention, when the user presses the "temporary isolation" button on the display screens, the function circuit of the sensing integrated circuit isolates the battery cell meeting the setting criterion from the battery network temporarily to avoid the deterioration of the degradation of the sensory battery cells. When the user presses the "power level balance" button on the display screens, the information platform 3000 issues a management instruction to the sensing integrated circuit 120 to cause the function circuit FC to perform a series connection power level balance between the battery cells in series connection or perform a parallel connection power level balance between sensory battery cells 100 in parallel connection, or cause the gateway integrated circuit 200 to perform a series connection power level balance between the intelligent batteries 500 in series connection.

According to the above embodiments of the present invention, the present invention further provides the following aspects.

The present invention provides a battery status display method for displaying the performance status of a power battery 1000 . The power battery 1000 includes a plurality of battery cells 1 and a plurality of sensing integrated circuits 120, the battery cells 1 are charged or discharged via a battery network (selected from one of a series network, a parallel network, a series-parallel network and a parallel-serial network), wherein a plurality of battery cells 1 constitute a sensing battery cell 100, a plurality of sensing battery cells 100 constitute a smart battery 500, and a plurality of smart batteries 500 constitute the power battery 1000. The sensing integrated circuits 120 sense each battery cell to measure performance parameters of each battery cell 1 (including but not limited to Vopen associated with battery temperature, internal resistance, and charge and discharge times). The battery status display method of the present invention comprises: obtaining the performance parameters of each battery cell 1 of the power battery 1000 from the plurality of sensing integrated circuits 120; displaying an equivalent battery symbol of the power battery 1000 on a display screen, and displaying information such as equivalent power, equivalent capacity, and related mileage of the power battery 1000 calculated based on the performance parameters of each battery cell 1, as shown in FIG. 16A.

The battery status display method of the present invention further provides: displaying a power battery 1000 composed of a plurality of smart batteries 500 in a battery network on the display screen; and selectively displaying information of any smart battery 500, the information being calculated based on the performance parameters of each battery cell constituting the smart battery 500, as shown in FIG. 16B.

The method for displaying battery state according to the present invention further provides: a power battery 1000 composed of a plurality of sensory battery cells 100 in a battery network; selectively displaying an information of any sensory battery cell 100, the information being calculated based on performance parameters of each of battery cells 1 constituting the sensory battery cell 100, including but not limited, equivalent power, equivalent capacity and degradation degree, as shown in FIG. 16C; marking in the battery network a position and a warning symbol of the sensory battery cell 100 that has reached a set condition; and receiving an instruction from the display screen to initiate an action against the sensory battery cell 100 that has reached the set condition, so that the information platform 3000 issues a management instruction to the sensing integrated circuit 120 of the sensory battery cell 100.

The method for displaying battery state according to the present invention further provides: displaying a power battery 1000 composed of the plurality of battery cells 1 in a battery network on the display screen; selectively displaying an information of any battery cell 1, the information being calculated based on performance parameters measured by the sensing integrated circuit 120, including but not limited to the power, capacity and degradation degree, as shown in FIG. 16D; marking in the battery network a position and a warning symbol of the battery cell 1 that has reached a critical state; and receiving an instruction from the display screen to initiate an action against the battery cell 1 that has reached the set condition, so that the information platform 3000 issues a management instruction to the sensing integrated circuit 120 connected in parallel to the battery cell 1 that has reached the set condition.

The present invention provides a battery state display system for displaying performance status of a power battery 1000. The power battery 1000 includes a plurality of battery cells 1 and a plurality of sensing integrated circuits 120, the battery cells are charged or discharged in a battery network (selected from one of a series network, a parallel network, a series-parallel network, and a parallel-serial network), wherein a plurality of battery cells 1 forms a sensory battery cell 100, a plurality of sensory battery cells 100 forms a smart battery 500, and a plurality of smart batteries 500 forms the power battery 1000. The sensing integrated circuits 120 sense each battery cell 1 to measure performance parameters of each battery cell 1 (including but not limited to Vopen associated with battery temperature, internal resistance, and charge and discharge times). The battery state display system of the present invention comprises: a display screen, a communication interface, and a processing unit. The display screen is used to display the battery network of the plurality of battery cells 1. The communication interface receives information of the power battery 1000 obtained based on the performance parameters of each battery cell measured by a plurality of sensing integrated circuits 120. The processing unit displays the battery network on the display screen and marks a position of the battery cell 1 that has reached a critical state on the battery network, or marks the position of the sensory battery cell 100 or the smart battery 500 that contain the battery cell 1 that has reached the critical state, and displays the performance parameters of the battery cell 1, or relevant information of the sensory battery cell 100, the smart battery 500, or the power battery 1000 on the display screen.

However, it should be understood that the various specific embodiments of the present invention are only for illustrative purposes, and various changes may be made without departing from the scope and spirit of the patent application of the present invention, and all should be included in the patent scope of the present invention. Therefore, the specific embodiments described in this specification are not intended to limit the present invention, and the true scope and spirit of the present invention are disclosed in the following claims.

## Claims

1. A sensing integrated circuit for sensing a plurality of battery cells, comprising:
a plurality of pins, a portion of which being used to connect to each battery cell in parallel;
a battery measurement circuit, electrically connected to the portion of the plurality of the pins to measure the voltage of each battery cell;
a function circuit electrically connected to the plurality of battery cells; and
an MCU, electrically connected to the battery measurement circuit to measure performance parameters of each battery cell;
wherein, the MCU controls the function circuit to take an action for at least one of the plurality of battery cells based on the performance parameters of the battery cell.

2. A sensing integrated circuit for sensing a plurality of battery cells, comprising:
a plurality of pins, a portion of which being used to connect to each battery cell in parallel;
a battery measurement circuit, electrically connected to the portion of the pins to measure the voltage of each battery cell;
a function circuit electrically connected to the plurality of battery cells; and
an MCU, electrically connected to the battery measurement circuit to measure performance parameters of each battery cell;
wherein the function circuit includes a loop switch which is controlled by the MCU to cut off a charging or discharging loop of the battery cells.

3. A gateway integrated circuit for transmitting performance parameters of a plurality of battery cells, comprising:
a first communication module, receiving a plurality of performance parameters of the battery cells from at least one sensing integrated circuit, wherein the sensing integrated circuit measures the performance parameters of the battery cell;
a second communication module, transmitting the performance parameters of the battery cells to a battery management system configured for evaluating degradation of the plurality of battery cells; and
an MCU, electrically connected to the first communication module and the second communication module.

4. An Intelligent battery, comprising:
a plurality of sensory battery cells, arranged in a second battery network, each sensory battery cell comprising a plurality of battery cells arranged in a first battery network; and
a sensing integrated circuit, connected in parallel to each battery cell to measure
at least one gateway integrated circuit, electrically connected to the plurality of sensory battery cells, the gateway integrated circuit communicating with the sensing integrated circuit of each sensory battery cell to receive the performance
parameters of each battery cell and transmit the performance parameters of each battery cell to a battery management system.

5. A power battery, comprising:
a plurality of battery cells, arranged in a battery network to be charged or discharged, wherein the battery network is selected from one of a series network, a parallel network, a series-parallel network and a parallel-series network; and
a plurality of sensing integrated circuits, each sensing integrated circuit being connected in parallel to at least one battery cell or a plurality of battery cells connected in series or in parallel, to measure performance parameters of each battery cell;
wherein when a degradation degree of one of the battery cells reaches a set condition, the sensing integrated circuit connected in parallel with the battery cell that reaches the set condition can take an action for the battery cell that reaches the set condition.

6. A power battery, comprising:
a plurality of battery cells, arranged in a battery network to be charged or discharged, wherein the battery network is selected from one of a series network, a parallel network, a series-parallel network and a parallel-series network; and
a plurality of sensing integrated circuits, each sensing integrated circuit being connected in parallel to at least one battery cell or a plurality of battery cells connected in series or in parallel, to measure the voltage of each battery cell;
wherein the sensing integrated circuit controls a loop switch to temporarily cut off the charging or discharging of the parallel battery cells, thereby measuring an open circuit voltage of each battery cell to define a state of charge (SOC) of the power battery.

7. A power battery, comprising:
a plurality of battery cells, arranged in a battery network to be charged or discharged, wherein the battery network is selected from one of a series network, a parallel network, a series-parallel network and a parallel-series network; and
a plurality of sensing integrated circuits, each sensing integrated circuit connected in parallel to at least one battery cell or a plurality of battery cells connected in series or in parallel, to measure a terminal voltage and a battery current of each battery cell;
wherein the sensing integrated circuit measures an internal resistance of each battery cell according to the terminal voltage and the battery current of each battery cell, to evaluate the health or service life of the power battery.

8. A battery power management method for managing a plurality of battery cells arranged in a battery network to charge or discharge, comprising:
measuring by a sensing integrated circuit each battery cell to measure performance parameters of each battery cell, wherein the sensing integrated circuit is connected in parallel to each battery cell; and
controlling by the sensing integrated circuit a function circuit to take an action for at least one of the plurality of battery cells based on the performance parameter of the battery cell.

9. A battery power management method for at least one sensing integrated circuit, the sensing integrated circuit connected in parallel to a portion of a plurality of battery cells, and the plurality of battery cells configured to discharge to a terminal device or be charged by the terminal device, the battery power management method comprising:
Disconnecting a charging or discharging loop of the portion of battery cells temporarily to measure an open circuit voltage of each battery cell of the portion of battery cells; and
defining a state of charge (SOC) of the power battery according to the open circuit voltage of each battery cell.

10. A battery power management method for at least one intelligent battery, the intelligent battery comprising a plurality of sensory battery cells and at least one gateway integrated circuit, and each sensory battery cell comprising a plurality of battery cells and a sensing integrated circuit, the battery power management method comprising:
charging or discharging a terminal device by a plurality of battery cells arranged in a first battery network with the sensing integrated circuit connected in parallel to each battery cell of the plurality of battery cells;
charging or discharging a terminal device by a plurality of sensory battery cells arranged in a second battery network;
measuring by the sensing integrated circuit each battery cell, and measuring performance parameters of each battery cell; and
receiving by the gateway integrated circuit the performance parameters of each battery cell from the sensing integrated circuits, and transmitting the performance parameters of the battery cells to a battery management system.

11. A battery power management method for a power battery, the power battery comprising a plurality of battery cells, a plurality of sensing integrated circuits and a plurality of gateway integrated circuits, the battery power management method comprising:
charging or discharging by a plurality of battery cells arranged in a battery network;
connecting each sensing integrated circuit in parallel to at least one battery cell or the plurality of battery cells connected in series or in parallel to measure performance parameters of each battery cell;
receiving by each gateway integrated circuit the performance parameters of each battery cell from a portion of the sensing integrated circuits, and transmitting the performance parameters of the battery cells to a battery management system.

12. A battery power management method for a power battery, the power battery comprising a plurality of intelligent batteries, each intelligent battery comprising a plurality of sensory battery cells and at least one gateway integrated circuit, each sensory battery cell comprising a plurality of battery cells and a sensing integrated circuit, the battery power management method comprising:
charging or discharging a terminal device by the plurality of intelligent batteries arranged in a third battery network;
charging or discharging the terminal device by the plurality of sensory battery cells arranged in a second battery network;
charging or discharging the terminal device by the plurality of battery cells arranged in a first battery network;
Connecting the sensing integrated circuit of each sensory battery cell in parallel to each battery cell to measure performance parameters of each battery cell; and
receiving by each gateway integrated circuit the performance parameters of each battery cell from a portion of the sensing integrated circuits, and transmitting the performance parameters of the battery cells to a battery management system.

13. The battery power management method as claimed in claim 10, 11 or 12, further comprising:
disconnecting by each sensing integrated circuit a charging or discharging loop of the battery cells to measure a terminal voltage of each battery cell, thereby defining a state of charge (SOC) of the power battery.

14. The battery power management method as claimed in claim 10, 11 or 12, further comprising:
Measuring by each sensing integrated circuit an internal resistance of each battery cell based on the performance parameters of each battery cell, thereby evaluating the health or service life of the power battery.

15. The battery power management method as claimed in claim 10, 11 or 12, further comprising:
taking by each sensing integrated circuit an action for at least one of the plurality of battery cells based on the performance parameters of the battery cell.
